# EUROPEAN PATENT SPECIFICATION

(11) **EP 3 118 900 B1**
(45) Date of publication and mention of the grant of the patent: **01.01.2020**
(21) Application number: 16179228.8
(22) Date of filing: 13.07.2016
(51) Int. Cl.: H01L 27/12, H01L 29/49, H01L 29/786

(54) **FIELD-EFFECT TRANSISTOR, DISPLAY ELEMENT, IMAGE DISPLAY DEVICE, AND SYSTEM**
FELDEFFEKTTRANSISTOR, ANZEIGEELEMENT, BILDANZEIGEVORRICHTUNG UND SYSTEM
TRANSISTOR À EFFET DE CHAMP, ÉLÉMENT D'AFFICHAGE, DISPOSITIF D'AFFICHAGE D'IMAGE ET SYSTÈME

(30) Priority: 14.07.2015 JP 2015140568
(43) Date of publication of application: 18.01.2017
(73) Proprietor: Ricoh Company, Ltd., Tokyo 143-8555 (JP)
(72) Inventor: SAOTOME, Ryoichi, Tokyo, 143-8555 (JP); UEDA, Naoyuki, Tokyo, 143-8555 (JP); NAKAMURA, Yuki, Tokyo, 143-8555 (JP); ABE, Yukiko, Tokyo, 143-8555 (JP); MATSUMOTO, Shinji, Tokyo, 143-8555 (JP); SONE, Yuji, Tokyo, 143-8555 (JP); ARAE, Sadanori, Tokyo, 143-8555 (JP); KUSAYANAGI, Minehide, Tokyo, 143-8555 (JP)
(74) Representative: SSM Sandmair

(56) References cited:
- WO-A1-2015/064670
- US-A1- 2011 168 994
- US-A1- 2012 248 451

## Description

### BACKGROUND OF THE INVENTION

### Field of the Invention

The present disclosure relates to field-effect transistors, display elements, image display devices, and systems.

### Description of the Related Art

Field-effect transistors (FETs) are transistors which control electric current between a source electrode and a drain electrode based on the principle that an electric field is applied to a gate electrode to provide a gate in a flow of electrons or holes utilizing an electric field of a channel.

By virtue of their characteristics, the FETs have been used as, for example, switching elements and amplifying elements. The FETs are low in gate current and have a flat structure, and thus can be easily produced and integrated as compared with bipolar transistors. For these reasons, the FETs are essential elements in integrated circuits used in the existing electronic devices. The FETs have been applied to, for example, active matrix displays as thin film transistor (TFTs).

In recent years, flat panel displays (FPDs), liquid crystal displays (LCDs), organic electroluminescent (EL) displays, and electronic paper have been put into practice.

These FPDs are driven by a driving circuit containing TFTs using amorphous silicon or polycrystalline silicon in an active layer. The FPDs have been required to have an increased size, improved definition and image quality, and an increased driving speed. To this end, there is a need for TFTs that have high carrier mobility, a high on/off ratio, small changes in properties over time, and small variation between the elements.

However, amorphous silicon or polycrystalline silicon have advantages and disadvantages. It was therefore difficult to satisfy all of the above requirements at the same time. In order to respond to these requirements, developments have been actively conducted on TFTs using, in an active layer, an oxide semiconductor the mobility of which can be expected to be higher than amorphous silicon. For example, disclosed is a TFT using InGaZnO₄ in a semiconductor layer (see, for example, K. Nomura, and 5 others "Room-temperature fabrication of transparent flexible thin film transistors using amorphous oxide semiconductors", NATURE, VOL. 432, 25, NOVEMBER, 2004, pp. 488 to 492 (hereinafter may be referred to as Non-Patent Literature 1)).

The TFTs are required to have small change in threshold voltage. One factor underlying change in the threshold voltage of the TFTs is adsorption or desorption of, for example, moisture, hydrogen, and oxygen contained in the atmosphere to or from a semiconductor layer. Another factor underlying change in the threshold voltage of the TFTs is diffusion of hydrogen into a semiconductor layer via a gate insulating layer. The threshold voltage is also changed by repeating on and off of the TFTs many times for a long period of time. As a method for evaluating change in threshold voltage as a result of long-term driving and on and off operations repeated many times, a bias temperature stress (BTS) test has been generally performed. The BTS test is a method of continuously applying a constant voltage between a gate electrode and a source electrode of a field-effect transistor to evaluate change in the threshold voltage or is a method of applying a constant voltage between a gate electrode and a source electrode of a field-effect transistor and between a drain electrode and the source electrode of the field-effect transistor to evaluate change in the threshold voltage.

Approaches to prevention of such change in threshold voltage of the TFTs due to the above factors include approaches associated with a passivation layer and approaches associated with a gate insulating layer.

As an approach associated with a passivation layer to prevent change in the threshold voltage of the TFT, disclosed is a field-effect transistor containing, as a passivation layer, a single-layer film of SiO₂, Si₃N₄, SiON, Al₂O₃, Ta₂O₅, TiO₂, HfO₂, ZrO₂, or Y₂O₃ or a laminated film of films of these materials (see, for example, Japanese Unexamined Patent Application Publication No. 2010-135462 (hereinafter may be referred to as Patent Literature 1)). Moreover, disclosed is a field-effect transistor containing a passivation layer of SiO₂ (see, for example, Y. Ohta, 11 others "Amorphous In-Ga-Zn-O TFT-LCDs with high reliability", IDW'09, 2009, pp. 1685-1688 (hereinafter may be referred to as Non-Patent Literature 2)).

As an approach associated with a gate insulating layer to prevent change in the threshold voltage of the TFT, disclosed is a field-effect transistor containing a gate insulating layer the hydrogen content of which is less than 3.0 × 10²¹ (atoms/cm³) (see, for example, Japanese Unexamined Patent Application Publication No. 2012-248883 (hereinafter may be referred to as Patent Literature 2)).

Meanwhile, it is desired that the TFTs have excellent TFT characteristics. Here, the excellent TFT characteristics mean, for example, a high mobility, a high on/off ratio, a low subthreshold swing (SS), and threshold voltage (Vth) of around 0 V.

In a process for forming the passivation layer of the TFT, however, oxygen is desorbed from a semiconductor layer by heat or plasma and as a result, TFT characteristics are changed or deteriorated. As an approach to prevention of such changes in the TFT characteristics in a process for forming a passivation layer, disclosed is a field-effect transistor containing a passivation layer including an oxygen permeation film and an oxygen barrier film (see, for example, Japanese Unexamined Patent Application Publication No. 2010-73894 (hereinafter may be referred to as Patent Literature 3)). Patent Literature 3 describes forming an oxygen permeation film so as to be in contact with a semiconductor layer and after TFT characteristics have been changed in a process for forming a passivation layer, performing a heat treatment to diffuse oxygen into the semiconductor layer to thereby recover the TFT characteristics. Patent Literature 3 also describes forming an oxygen barrier film after the formation of the oxygen permeation film and preventing oxygen in the atmosphere from being diffused in the semiconductor layer.

Moreover, as an attempt to realize excellent TFT characteristics, a material of a gate insulating layer has been carefully selected. Disclosed is a field-effect transistor in which a gate insulating layer has a laminated structure containing a silicon oxide layer and a multi-element oxide layer including lanthanum (La) and zirconium (Zr) (see, for example, Japanese Unexamined Patent Application Publication No. 2014-022549 (hereinafter may be referred to as Patent Literature 4).

WO 2015/064670 dislcoses a gate insulator based on La₂O₃.

US 2011/0168994 discloses a gate insulator comprising CaHfO₃.

### SUMMARY OF THE INVENTION

A field-effect transistor of the present disclosure as defined in the claims includes a substrate, a passivation layer, a gate insulating layer formed between the substrate and the passivation layer, a source electrode and a drain electrode, a semiconductor layer, and a gate electrode. The source electrode and the drain electrode are formed to be in contact with the gate insulating layer. The semiconductor layer is formed at least between the source electrode and the drain electrode and is in contact with the gate insulating layer, the source electrode, and the drain electrode. The gate electrode is in contact with the gate insulating layer and faces the semiconductor layer via the gate insulating layer. The passivation layer contains a first complex oxide containing an alkaline earth metal and a rare-earth element. The gate insulating layer contains a second complex oxide containing an alkaline earth metal and a rare-earth element.

### BRIEF DESCRIPTION OF THE DRAWINGS

FIG. 1 is a diagram for explaining an image display device;
FIG. 2 is a diagram for explaining one example of a display element of the present disclosure;
FIG. 3A is a view illustrating one example (bottom contact/bottom gate) of a field-effect transistor of the present disclosure;
FIG. 3B is a view illustrating one example (top contact/bottom gate) of a field-effect transistor of the present disclosure;
FIG. 3C is a view illustrating one example (bottom contact/top gate) of a field-effect transistor of the present disclosure;
FIG. 3D is a view illustrating one example (top contact/top gate) of a field-effect transistor of the present disclosure;
FIG. 4 is a schematic structural view illustrating one example of an organic EL element;
FIG. 5 is a schematic structural view illustrating one example of a display element of the present disclosure;
FIG. 6 is a schematic structural view illustrating another example of a display element of the present disclosure;
FIG. 7 is a diagram for explaining a display control device;
FIG. 8 is a diagram for explaining a liquid crystal display;
FIG. 9 is a diagram for explaining a display element in FIG. 8;
FIG. 10 is a schematic view illustrating field-effect transistors produced in Examples 1 to 15 and Comparative Examples 1 to 6;
FIG. 11 is a graph in which transistor characteristics (Vgs-Ids) of a field-effect transistor obtained in Example 12 before and after formation of a passivation layer are evaluated;
FIG. 12 is a graph in which transistor characteristics (Vgs-Ids) of a field-effect transistor obtained in Comparative Example 1 before and after formation of a passivation layer are evaluated;
FIG. 13 is a graph in which transistor characteristics (Vgs-Ids) of a field-effect transistor obtained in Example 12 in a BTS test with Vgs = +10 V and Vds = 0 V are evaluated;
FIG. 14 is a graph in which change ΔVth with respect to stress time of field-effect transistors obtained in Example 12 and Comparative Example 1 in a BTS test with Vgs = +10 V and Vds = 0 V are evaluated.

### DESCRIPTION OF THE EMBODIMENTS

It has been reported that the field-effect transistor containing the passivation layer described in Patent Literature 1 can prevent desorption of oxygen from an oxide semiconductor layer and can improve reliability. Patent Literature 1 however does not disclose any data related to a BTS test and therefore it cannot be said that sufficient reliability mentioned in the present disclosure can be assured in Patent Literature 1.

The field-effect transistor containing a passivation layer described in Non-Patent Literature 2 is evaluated for reliability by a BTS test. However, there is a larger change of threshold voltage (ΔVth) as the test time passes and therefore it cannot be said that sufficient reliability mentioned in the present disclosure can be assured in Non-Patent Literature 2.

It has been reported that the field-effect transistor containing a gate insulating layer described in Patent Literature 2 can be stably operated for a long period of time because a hydrogen content in the gate insulating layer is small. Patent Literature 2 however does not disclose any data related to a BTS test and therefore it cannot be said that sufficient reliability mentioned in the present disclosure can be assured in Patent Literature 2.

Accordingly, there is a need for provision of a field-effect transistor having a small change of threshold voltage in a BTS test and having high reliability.

The field-effect transistor described in Patent Literature 3, which has changed in TFT characteristics because the semiconductor layer is damaged once by the formation of an oxygen permeation film, is attempted to be recovered in the TFT characteristics by a heat treatment. Patent Literature 3 however does not provide a fundamental solution to a problem that the TFT characteristics change at the time of the formation of the passivation layer.

It has been reported that the field-effect transistor described in Patent Literature 4 can assure excellent transistor characteristics by appropriately combining a material of a semiconductor layer and a material of a gate insulating layer. Patent Literature 4 however does not disclose any data related to a BTS test and therefore it cannot be said that sufficient reliability mentioned in the present disclosure can be assured in Patent Literature 4.

Accordingly, it is currently desired to provide field-effect transistors exhibiting excellent TFT characteristics, being capable of maintaining the excellent TFT characteristics even after a process for forming a passivation layer, having a small change of threshold voltage in a BTS test, and having high reliability.

Therefore, the present disclosure has an object to provide a field-effect transistor exhibiting excellent TFT characteristics, being capable of maintaining the excellent TFT characteristics even after a process for forming a passivation layer, and having a small change of threshold voltage in a BTS test.

The present disclosure can solve the above various existing problems. Specifically, the present disclosure can provide a field-effect transistor a passivation layer of which contains a first complex oxide containing an alkaline earth metal and a rare-earth element. As a result, the field-effect transistor of the present disclosure is suppressed in terms of change in threshold voltage in a BTS test and has high reliability.

Moreover, the gate insulating layer contains a second complex oxide containing an alkaline earth metal and a rare-earth element. Therefore, drain current rapidly rises at around 0 V upon the application of gate voltage, making it possible to obtain high drain current. Accordingly, the field-effect transistor having excellent TFT characteristics can be obtained.

The field-effect transistor has a structure where the passivation layer and the gate insulating layer are combined. Therefore, it is possible to provide a field-effect transistor having excellent TFT characteristics and being capable of maintaining the excellent TFT characteristics even after the process for forming a passivation layer. Moreover, combination of the passivation layer and the gate insulating layer can provide a field-effect transistor having a smaller change of threshold voltage in a BTS test and having higher reliability as compared with a field-effect transistor containing only the passivation layer.

### (Field-effect transistor)

A field-effect transistor of the present disclosure includes a substrate, a passivation layer, a gate insulating layer, a source electrode, a drain electrode, a semiconductor layer, and a gate electrode, and further contains other members according to the necessity.

### < Substrate>

A shape, a structure, and a size of the substrate are not particularly limited and may be appropriately selected depending on the intended purpose.

A material of the substrate is not particularly limited and may be appropriately selected depending on the intended purpose. Examples of the material of the substrate include glass and plastics.

The glass is not particularly limited and may be appropriately selected depending on the intended purpose. Examples of the glass include non-alkali glass and silica glass.

The plastics are not particularly limited and may be appropriately selected depending on the intended purpose. Examples of the plastics include polycarbonate (PC), polyimide (PI), polyethylene terephthalate (PET), and polyethylene naphthalate (PEN).

Note that, pre-treatments, such as oxygen plasma, UV ozone, and UV radiation washing, are preferably performed on the substrate to clean a surface of the substrate and improve adhesiveness.

### <Passivation layer>

The passivation layer is typically formed above the substrate.

The passivation layer contains a first complex oxide.

The passivation layer is made of the first complex oxide itself.

### -First complex oxide-

The first complex oxide contains at least an alkaline earth metal and a rare-earth element, and contains at least one of Zr (zirconium) and Hf (hafnium), and further contains other components according to the necessity.

The first complex oxide is stable in the atmosphere and can stably form an amorphous structure in a wide range of compositions. This results from the finding obtained by the present inventors that complex oxides containing an alkaline earth metal and a rare-earth element are stable in the atmosphere and can stably form an amorphous structure in a wide range of compositions.

Typically, simple oxides of alkaline earth metals tend to react with moisture or carbon dioxide in the atmosphere to easily form hydroxides or carbonates and therefore such simple oxides alone are not suitable for use in electronic devices. Moreover, simple oxides of rare-earth elements tend to be crystallized and problematically cause leakage current when attempted to be used in electronic devices. However, the present inventors have found that the first complex oxide containing an alkaline earth metal and a rare-earth element stably forms an amorphous film in a wide range of compositions. Because the first complex oxide is stably present in a wide range of compositions, a dielectric constant and a linear expansion coefficient of the first complex oxide to be formed can be variably controlled depending on the compositional ratio.

In the present disclosure, the present inventors have found that the passivation layer containing the first complex oxide exhibits excellent barrier properties against moisture, oxygen, and hydrogen in the atmosphere.

Therefore, use of the passivation layer can provide a field-effect transistor exhibiting high reliability.

The first complex oxide also contains at least one of Zr (zirconium) and Hf (hafnium). When the first complex oxide contains at least one of the Zr and the Hf, thermal stability, heat resistance, and denseness can be further improved.

Examples of the alkaline earth metal in the first complex oxide include Be (beryllium), Mg (magnesium), Ca (calcium), Sr (strontium), and Ba (barium). These alkaline earth metals may be used alone or in combination.

Examples of the rare-earth element in the first complex oxide include Sc (scandium), Y (yttrium), La (lanthanum), Ce (cerium), Pr (praseodymium), Nd (neodymium), Pm (promethium), Sm (samarium), Eu (europium), Gd (gadolinium), Tb (terbium), Dy (dysprosium), Ho (holmium), Er (erbium), Tm (thulium), Yb (ytterbium), and Lu (lutetium).

A compositional ratio between the alkaline earth metal and the rare-earth element in the first complex oxide is not particularly limited and may be appropriately selected depending on the intended purpose. However, the compositional ratio is preferably within the following range.

In the first complex oxide, the compositional ratio between the alkaline earth metal and the rare-earth element (the alkaline earth metal : the rare-earth element) is preferably from 10.0 mol% through 67.0 mol% : from 33.0 mol% through 90.0 mol% based on the amounts converted to the corresponding oxides (BeO, MgO, CaO, SrO, BaO, Sc₂O₃, Y₂O₃, La₂O₃, Ce₂O₃, Pr₂O₃, Nd₂O₃, Pm₂O₃, Sm₂O₃, Eu₂O₃, Gd₂O₃, Tb₂O₃, Dy₂O₃, Ho₂O₃, Er₂O₃, Tm₂O₃, Yb₂O₃, and Lu₂O₃).

A compositional ratio among the alkaline earth metal, the rare-earth element, and at least one of the Zr and the Hf in the first complex oxide is not particularly limited and may be appropriately selected depending on the intended purpose. However, the compositional ratio is preferably within the following range.

In the first complex oxide, the compositional ratio among the alkaline earth metal, the rare-earth element, and at least one of the Zr and the Hf (the alkaline earth metal : the rare-earth element : at least one of the Zr and the Hf) is preferably from 5.0 mol% through 22.0 mol% : from 33.0 mol% through 90.0 mol% : from 5.0 mol% through 45.0 mol% based on the amounts converted to the corresponding oxides (BeO, MgO, CaO, SrO, BaO, Sc₂O₃, Y₂O₃, La₂O₃, Ce₂O₃, Pr₂O₃, Nd₂O₃, Pm₂O₃, Sm₂O₃, Eu₂O₃, Gd₂O₃, Tb₂O₃, Dy₂O₃, Ho₂O₃, Er₂O₃, Tm₂O₃, Yb₂O₃, Lu₂O₃, ZrO₂, and HfO₂).

The ratios of the oxides (BeO, MgO, CaO, SrO, BaO, Sc₂O₃, Y₂O₃, La₂O₃, Ce₂O₃, Pr₂O₃, Nd₂O₃, Pm₂O₃, Sm₂O₃, Eu₂O₃, Gd₂O₃, Tb₂O₃, Dy₂O₃, Ho₂O₃, Er₂O₃, Tm₂O₃, Yb₂O₃, Lu₂O₃, ZrO₂, and HfO₂) in the first complex oxide can be calculated, for example, by analyzing a cationic element of the oxide through X-ray fluorescence spectrometry, electron probe microanalysis (EPMA), or inductively coupled plasma atomic emission spectroscopy (ICP-AES).

A dielectric constant of the passivation layer is not particularly limited and may be appropriately selected depending on the intended purpose.

The dielectric constant can be measured, for example, by producing a capacitor, in which a lower electrode, a dielectric layer (the passivation layer), and an upper electrode are laminated, and measuring the produced capacitor using an LCR meter.

A linear expansion coefficient of the passivation layer is not particularly limited and may be appropriately selected depending on the intended purpose.

The linear expansion coefficient can be measured, for example, by using a thermomechanical analysis device. In this measurement, the linear expansion coefficient can be measured by separately producing a measurement sample having the same composition as the passivation layer, without producing the field-effect transistor.

### -Formation method of passivation layer-

A formation method of the passivation layer is not particularly limited and may be appropriately selected depending on the intended purpose. Examples of the formation method include a method of forming a film by a vacuum process, such as sputtering, pulsed laser deposition (PLD), chemical vapor deposition (CVD), or atomic layer deposition (ALD) and patterning the film through photolithography.

Moreover, the passivation layer can be formed by preparing a coating liquid containing a precursor of the first complex oxide (a passivation-layer-coating liquid), coating or printing the coating liquid onto an object to be coated, and baking the resultant under appropriate conditions.

An average film thickness of the passivation layer is preferably from 10 nm through 1,000 nm, more preferably from 20 nm through 500 nm.

### --Passivation-layer-coating liquid--

The passivation-layer-coating liquid contains at least an alkaline-earth-metal-containing compound, a rare-earth-element-containing compound, and a solvent, preferably contains at least one of a zirconium-containing compound and a hafnium-containing compound, and further contains other components according to the necessity.

### ---Alkaline-earth-metal-containing compound---

Examples of the alkaline-earth-metal-containing compound include inorganic alkaline earth metal compounds and organic alkaline earth metal compounds. Examples of alkaline earth metals in the alkaline-earth-metal-containing compound include Be (beryllium), Mg (magnesium), Ca (calcium), Sr (strontium), and Ba (barium).

Examples of the inorganic alkaline earth metal compounds include alkaline earth metal nitrate, alkaline earth metal sulfate, alkaline earth metal chlorides, alkaline earth metal fluorides, alkaline earth metal bromides, and alkaline earth metal iodides.

Examples of the alkaline earth metal nitrate include magnesium nitrate, calcium nitrate, strontium nitrate, and barium nitrate.

Examples of the alkaline earth metal sulfate include magnesium sulfate, calcium sulfate, strontium sulfate, and barium sulfate.

Examples of the alkaline earth metal chlorides include magnesium chloride, calcium chloride, strontium chloride, and barium chloride.

Examples of the alkaline earth metal fluorides include magnesium fluoride, calcium fluoride, strontium fluoride, and barium fluoride.

Examples of the alkaline earth metal bromides include magnesium bromide, calcium bromide, strontium bromide, and barium bromide.

Examples of the alkaline earth metal iodides include magnesium iodide, calcium iodide, strontium iodide, and barium iodide.

The organic alkaline earth metal compounds are not particularly limited and may be appropriately selected depending on the intended purpose, so long as the organic alkaline earth metal compounds are each a compound containing an alkaline earth metal and an organic group. The alkaline earth metal and the organic group are bonded, for example, via an ionic bond, a covalent bond, or a coordinate bond.

The organic group is not particularly limited and may be appropriately selected depending on the intended purpose. Examples of the organic group include alkyl groups which may have a substituent, alkoxy groups which may have a substituent, acyloxy groups which may have a substituent, phenyl groups which may have a substituent, acetyl acetonate groups which may have a substituent, and sulfonic acid groups which may have a substituent. Examples of the alkyl groups include alkyl groups containing from 1 through 6 carbon atoms. Examples of the alkoxy groups include alkoxy groups containing from 1 through 6 carbon atoms. Examples of the acyloxy groups include: acyloxy groups containing from 1 through 10 carbon atoms; acyloxy groups part of which is substituted with a benzene ring, such as benzoic acid; acyloxy groups part of which is substituted with a hydroxyl group, such as lactic acid; and acyloxy groups containing two or more carbonyl groups, such as oxalic acid and citric acid.

Examples of the organic alkaline earth metal compound include magnesium methoxide, magnesium ethoxide, diethyl magnesium, magnesium acetate, magnesium formate, acetylacetone magnesium, magnesium 2-ethylhexanoate, magnesium lactate, magnesium naphthenate, magnesium citrate, magnesium salicylate, magnesium benzoate, magnesium oxalate, magnesium trifluromethanesulfonate, calcium methoxide, calcium ethoxide, calcium acetate, calcium formate, acetylacetone calcium, calcium dipivaloyl methanate, calcium 2-ethylhexanoate, calcium lactate, calcium naphthenate, calcium citrate, calcium salicylate, calcium neodecanoate, calcium benzoate, calcium oxalate, strontium isopropoxide, strontium acetate, strontium formate, acetylacetone strontium, strontium 2-ethylhexanoate, strontium lactate, strontium naphthenate, strontium salicylate, strontium oxalate, barium ethoxide, barium isopropoxide, barium acetate, barium formate, acetylacetone barium, barium 2-ethylhexanoate, barium lactate, barium naphthenate, barium neodecanoate, barium oxalate, barium benzoate, and barium trifluoromethane- sulfonate.

An amount of the alkaline-earth-metal-containing compound in the passivation-layer-coating liquid is not particularly limited and may be appropriately selected depending on the intended purpose.

### ---Rare-earth-element-containing compound---

Examples of rare-earth elements in the rare-earth-element-containing compound include Sc (scandium), Y (yttrium), La (lanthanum), Ce (cerium), Pr (praseodymium), Nd (neodymium), Pm (promethium), Sm (samarium), Eu (europium), Gd (gadolinium), Tb (terbium), Dy (dysprosium), Ho (holmium), Er (erbium), Tm (thulium), Yb (ytterbium), and Lu (lutetium).

Examples of the rare-earth-element-containing compound include inorganic rare-earth compounds and organic rare-earth compounds.

Examples of the inorganic rare-earth compounds include rare-earth nitrate, rare-earth sulfate, rare-earth fluorides, rare-earth chlorides, rare-earth bromides, and rare-earth iodides.

Examples of the rare-earth nitrate include scandium nitrate, yttrium nitrate, lanthanum nitrate, cerium nitrate, praseodymium nitrate, neodymium nitrate, samarium nitrate, europium nitrate, gadolinium nitrate, terbium nitrate, dysprosium nitrate, holmium nitrate, erbium nitrate, thulium nitrate, ytterbium nitrate, and lutetium nitrate.

Examples of the rare-earth sulfate include scandium sulfate, yttrium sulfate, lanthanum sulfate, cerium sulfate, praseodymium sulfate, neodymium sulfate, samarium sulfate, europium sulfate, gadolinium sulfate, terbium sulfate, dysprosium sulfate, holmium sulfate, erbium sulfate, thulium sulfate, ytterbium sulfate, and lutetium sulfate.

Examples of the rare-earth fluorides include scandium fluoride, yttrium fluoride, lanthanum fluoride, cerium fluoride, praseodymium fluoride, neodymium fluoride, samarium fluoride, europium fluoride, gadolinium fluoride, terbium fluoride, dysprosium fluoride, holmium fluoride, erbium fluoride, thulium fluoride, ytterbium fluoride, and lutetium fluoride.

Examples of the rare-earth chlorides include scandium chloride, yttrium chloride, lanthanum chloride, cerium chloride, praseodymium chloride, neodymium chloride, samarium chloride, europium chloride, gadolinium chloride, terbium chloride, dysprosium chloride, holmium chloride, erbium chloride, thulium chloride, ytterbium chloride, and lutetium chloride.

Examples of the rare-earth bromides include scandium bromide, yttrium bromide, lanthanum bromide, praseodymium bromide, neodymium bromide, samarium bromide, europium bromide, gadolinium bromide, terbium bromide, dysprosium bromide, holmium bromide, erbium bromide, thulium bromide, ytterbium bromide, and lutetium bromide.

Examples of the rare-earth iodides include scandium iodide, yttrium iodide, lanthanum iodide, cerium iodide, praseodymium iodide, neodymium iodide, samarium iodide, europium iodide, gadolinium iodide, terbium iodide, dysprosium iodide, holmium iodide, erbium iodide, thulium iodide, ytterbium iodide, and lutetium iodide.

The organic rare-earth compound is not particularly limited and may be appropriately selected depending on the intended purpose, so long as the organic rare-earth compound is a compound containing a rare-earth element and an organic group. The rare-earth element and the organic group are bonded, for example, via an ionic bond, a covalent bond, or a coordinate bond.

The organic group is not particularly limited and may be appropriately selected depending on the intended purpose. Examples of the organic group include alkyl groups which may have a substituent, alkoxy groups which may have a substituent, acyloxy groups which may have a substituent, acetyl acetonate groups which may have a substituent, and cyclopentadienyl groups which may have a substituent. Examples of the alkyl groups include alkyl groups containing from 1 through 6 carbon atoms. Examples of the alkoxy groups include alkoxy groups containing from 1 through 6 carbon atoms. Examples of the acyloxy groups include acyloxy groups containing from 1 through 10 carbon atoms.

Examples of the organic rare-earth compound include scandium isopropoxide, scandium acetate, tris(cyclopentadienyl)scandium, yttrium isopropoxide, yttrium 2-ethylhexanoate, tris(acetylacetonato)yttrium, tris(cyclopentadienyl)yttrium, lanthanum isopropoxide, lanthanum 2-ethylhexanoate, tris(acetylacetonato)lanthanum, tris(cyclopentadienyl)lanthanum, cerium 2-ethylhexanoate, tris(acetylacetonato)cerium, tris(cyclopentadienyl)cerium, praseodymium isopropoxide, praseodymium oxalate, tris(acetylacetonato)praseodymium, tris(cyclopentadienyl)praseodymium, neodymium isopropoxide, neodymium 2-ethylhexanoate, neodymium trifluoroacetylacetonate, tris(isopropylcyclopentadienyl)neodymium, tris(ethylcyclopentadienyl)promethium, samarium isopropoxide, samarium 2-ethylhexanoate, tris(acetylacetonato)samarium, tris(cyclopentadienyl)samarium, europium 2-ethylhexanoate, tris(acetylacetonato)europium, tris(ethylcyclopentadienyl)europium, gadolinium isopropoxide, gadolinium 2-ethylhexanoate, tris(acetylacetonato)gadolinium, tris(cyclopentadienyl)gadolinium, terbium acetate, tris(acetylacetonato)terbium, tris(cyclopentadienyl)terbium, dysprosium isopropoxide, dysprosium acetate, tris(acetylacetonato)dysprosium, tris(ethylcyclopentadienyl)dysprosium, holmium isopropoxide, holmium acetate, tris(cyclopentadienyl)holmium, erbium isopropoxide, erbium acetate, tris(acetylacetonato)erbium, tris(cyclopentadienyl)erbium, thulium acetate, tris(acetylacetonato)thulium, tris(cyclopentadienyl)thulium, ytterbium isopropoxide, ytterbium acetate, tris(acetylacetonato)ytterbium, tris(cyclopentadienyl)ytterbium, lutetium oxalate, and tris(ethylcyclopentadienyl)lutetium.

An amount of the rare-earth-element-containing compound in the passivation-layer-coating liquid is not particularly limited and may be appropriately selected depending on the intended purpose.

### ---Zirconium-containing compound---

Examples of the zirconium-containing compound include inorganic zirconium compounds and organic zirconium compounds.

Examples of the inorganic zirconium compounds include zirconium fluoride, zirconium chloride, zirconium bromide, zirconium iodide, zirconium carbonate, and zirconium sulfate.

The organic zirconium compounds are not particularly limited and may be appropriately selected depending on the intended purpose, so long as the organic zirconium compounds are each a compound containing zirconium and an organic group. The zirconium and the organic group are bonded, for example, via an ionic bond, a covalent bond, or a coordinate bond.

The organic group is not particularly limited and may be appropriately selected depending on the intended purpose. Examples of the organic group include alkyl groups which may have a substituent, alkoxy groups which may have a substituent, acyloxy groups which may have a substituent, acetylacetonate groups which may have a substituent, and cyclopentadienyl groups which may have a substituent. Examples of the alkyl groups include alkyl groups containing from 1 through 6 carbon atoms. Examples of the alkoxy groups include alkoxy groups containing from 1 through 6 carbon atoms. Examples of the acyloxy groups include acyloxy groups containing from 1 through 10 carbon atoms.

Examples of the organic zirconium compounds include zirconium butoxide, zirconium isopropoxide, zirconium oxide 2-ethylhexanoate, zirconium di(n-butoxide) bisacetylacetonate, tetrakis(acetylacetonate) zirconium, and tetrakis(cyclopentadienyl) zirconium.

An amount of the zirconium-containing compound in the passivation-layer-coating liquid is not particularly limited and may be appropriately selected depending on the intended purpose.

### ---Hafnium-containing compound---

Examples of the hafnium-containing compound include inorganic hafnium compounds and organic hafnium compounds.

Examples of the inorganic hafnium compounds include hafnium fluoride, hafnium chloride, hafnium bromide, hafnium iodide, hafnium carbonate, and hafnium sulfate.

The organic hafnium compounds are not particularly limited and may be appropriately selected depending on the intended purpose, so long as the organic hafnium compounds are each a compound containing hafnium and an organic group. The hafnium and the organic group are bonded, for example, via an ionic bond, a covalent bond, or a coordinate bond.

The organic group is not particularly limited and may be appropriately selected depending on the intended purpose. Examples of the organic group include alkyl groups which may have a substituent, alkoxy groups which may have a substituent, acyloxy groups which may have a substituent, acetylacetonate groups which may have a substituent, and cyclopentadienyl groups which may have a substituent. Examples of the alkyl groups include alkyl groups containing from 1 through 6 carbon atoms. Examples of the alkoxy groups include alkoxy groups containing from 1 through 6 carbon atoms. Examples of the acyloxy groups include acyloxy groups containing from 1 through 10 carbon atoms.

Examples of the organic hafnium compounds include hafnium butoxide, hafnium isopropoxide, hafnium 2-ethylhexanoate, hafnium di(n-butoxide)bisacetylacetonate, tetrakis(acetylacetonate) hafnium, and bis(cyclopentadienyl)dimethyl hafnium.

An amount of the hafnium-containing compound in the passivation-layer-coating liquid is not particularly limited and may be appropriately selected depending on the intended purpose.

### ---Solvent---

The solvent is not particularly limited and may be appropriately selected depending on the intended purpose, so long as the solvent is capable of stably dissolving or dispersing the above various compounds. Examples of the solvent include toluene, xylene, mesitylene, cymene, pentylbenzene, dodecylbenzene, bicyclohexyl, cyclohexylbenzene, decane, undecane, dodecane, tridecane, tetradecane, pentadecane, tetralin, decalin, isopropanol, ethyl benzoate, N,N-dimethylformamide, propylene carbonate, 2-ethyl hexanoate, mineral spirits, dimethylpropylene urea, 4-butyrolactone, 2-methoxy ethanol, and water.

An amount of the solvent in the passivation-layer-coating liquid is not particularly limited and may be appropriately selected depending on the intended purpose.

A compositional ratio between the alkaline-earth-metal-containing compound and the rare-earth-element-containing compound (the alkaline-earth-metal-containing compound : the rare-earth-element-containing compound) in the passivation-layer-coating liquid is not particularly limited and may be appropriately selected depending on the intended purpose. However, the compositional ratio is preferably within the following range.

In the passivation-layer-coating liquid, the compositional ratio between the alkaline earth metal and the rare-earth element (the alkaline earth metal : the rare-earth element) is preferably from 10.0 mol% through 67.0 mol% : from 33.0 mol% through 90.0 mol% based on the amounts converted to the corresponding oxides (BeO, MgO, CaO, SrO, BaO, Sc₂O₃, Y₂O₃, La₂O₃, Ce₂O₃, Pr₂O₃, Nd₂O₃, Pm₂O₃, Sm₂O₃, Eu₂O₃, Gd₂O₃, Tb₂O₃, Dy₂O₃, Ho₂O₃, Er₂O₃, Tm₂O₃, Yb₂O₃, and Lu₂O₃).

A compositional ratio among the alkaline-earth-metal-containing compound, the rare-earth-element-containing compound, and at least one of the zirconium-containing compound and the hafnium-containing compound (the alkaline-earth-metal-containing compound : the rare-earth-element-containing compound : at least one of the zirconium-containing compound and the hafnium-containing compound) in the passivation-layer-coating liquid is not particularly limited and may be appropriately selected depending on the intended purpose. However, the compositional ratio is preferably within the following range.

In the passivation-layer-coating liquid, the compositional ratio among the alkaline earth metal, the rare-earth element, and at least one of the Zr and the Hf (the alkaline earth metal : the rare-earth element: at least one of the Zr and the Hf) is preferably from 5.0 mol% through 22.0 mol% : from 33.0 mol% through 90.0 mol% : from 5.0 mol% through 45.0 mol% based on the amounts converted to the corresponding oxides (BeO, MgO, CaO, SrO, BaO, Sc₂O₃, Y₂O₃, La₂O₃, Ce₂O₃, Pr₂O₃, Nd₂O₃, Pm₂O₃, Sm₂O₃, Eu₂O₃, Gd₂O₃, Tb₂O₃, Dy₂O₃, Ho₂O₃, Er₂O₃, Tm₂O₃, Yb₂O₃, Lu₂O₃, ZrO₂, and HfO₂).

### --Formation method of passivation layer using passivation-layer-coating liquid--

One example of a formation method of the passivation layer using the passivation-layer-coating liquid will be described. The formation method of the passivation layer contains a coating step and a heat treatment step and further contains other steps according to the necessity.

The coating step is not particularly limited and may be appropriately selected depending on the intended purpose, so long as the coating step is a step of coating the passivation-layer-coating liquid onto an object to be coated. A method of the coating is not particularly limited and may be appropriately selected depending on the intended purpose. Examples of the method include: a method of forming a film through a solution process and patterning the film through photolithography; and a method of directly forming a film having a desired shape by printing, such as inkjet printing, nanoimprinting, or gravure printing. Examples of the solution process include dip coating, spin coating, die coating, and nozzle printing.

The heat treatment step is not particularly limited and may be appropriately selected depending on the intended purpose, so long as the heat treatment step is a step of heat-treating the passivation-layer-coating liquid coated on the object to be coated. Note that, in the heat treatment step, the passivation-layer-coating liquid coated on the object to be coated may be dried through air drying. As a result of the heat treatment, the solvent is evaporated and the first complex oxide is generated.

In the heat treatment step, evaporation of the solvent (hereinafter referred to as "evaporation treatment") and generation of the first complex oxide (hereinafter referred to as "generation treatment") are preferably performed at different temperatures. Specifically, it is preferable that after the evaporation of the solvent, the temperature be elevated to generate the first complex oxide. At the time of generation of the first complex oxide, for example, at least one of the alkaline-earth-metal-containing compound, the rare-earth-element-containing compound, the zirconium-containing compound, and the hafnium-containing compound is decomposed.

A temperature of the evaporation treatment is not particularly limited and may be appropriately selected depending on the solvent contained. For example, the temperature of the evaporation treatment is from 80°C through 180°C. As for the evaporation, it is effective to use a vacuum oven for reducing the required temperature. The time of the evaporation treatment is not particularly limited and may be appropriately selected depending on the intended purpose. For example, the time of the evaporation treatment is from 10 minutes through 1 hour.

A temperature of the generation treatment is not particularly limited and may be appropriately selected depending on the intended purpose. However, the temperature of the generation treatment is preferably 100°C or higher but lower than 550°C, more preferably from 200°C through 500°C. The time of the generation treatment is not particularly limited and may be appropriately selected depending on the intended purpose. For example, the time of the generation treatment is from 1 hour through 5 hours.

Note that, in the heat treatment step, the evaporation treatment and the generation treatment may be continuously performed or may be performed in a divided manner of a plurality of steps.

A method of the heat treatment is not particularly limited and may be appropriately selected depending on the intended purpose. Examples of the method of the heat treatment include a method of heating the object to be coated. An atmosphere in the heat treatment is not particularly limited and may be appropriately selected depending on the intended purpose. However, the atmosphere is preferably an oxygen atmosphere. When the heat treatment is performed in the oxygen atmosphere, decomposed products can be promptly discharged to the outside of the system and generation of the first complex oxide can be accelerated.

In the heat treatment, in view of acceleration of reaction of the generation treatment, it is effective to apply ultraviolet rays having a wavelength of 400 nm or shorter to the material after the evaporation treatment. Applying the ultraviolet rays having a wavelength of 400 nm or shorter can cleave chemical bonds of the organic material contained in the material after the evaporation treatment and can decompose the organic material. Therefore, the first complex oxide can be efficiently formed. The ultraviolet rays having a wavelength of 400 nm or shorter are not particularly limited and may be appropriately selected depending on the intended purpose. Examples of the ultraviolet rays include ultraviolet rays having a wavelength of 222 nm emitted from an excimer lamp. It is also preferable to apply ozone instead of or in combination with the ultraviolet rays. Applying the ozone to the material after the evaporation treatment accelerates generation of the oxide.

### <Gate insulating layer>

The gate insulating layer contains a second complex oxide.

The gate insulating layer is preferably made of the second complex oxide itself.

### -Second complex oxide-

The second complex oxide contains at least an alkaline earth metal and a rare-earth element, and contains at least one of Zr (zirconium) and Hf (hafnium), and further contains other components according to the necessity.

Similar to the first complex oxide, the second complex oxide is stable in the atmosphere and can stably form an amorphous structure in a wide range of compositions. This results from the finding obtained by the present inventors that complex oxides containing an alkaline earth metal and a rare-earth element are stable in the atmosphere and can stably form an amorphous structure in a wide range of compositions.

Typically, simple oxides of alkaline earth metals tend to react with moisture or carbon dioxide in the atmosphere to easily form hydroxides or carbonates and therefore such simple oxides alone are not suitable for use in electronic devices. Moreover, simple oxides of rare-earth elements tend to be crystallized and problematically cause leakage current when attempted to be used in electronic devices. However, the present inventors have found that the second complex oxide containing an alkaline earth metal and a rare-earth element stably forms an amorphous film in a wide range of compositions. Because the second complex oxide is stably present in a wide range of compositions, a dielectric constant and a linear expansion coefficient of the second complex oxide to be formed can be variably controlled depending on the compositional ratio.

Because the field-effect transistor contains the gate insulating layer containing the second complex oxide, drain current of the field-effect transistor rapidly rises at around 0 V upon the application of gate voltage, making it possible to obtain high drain current. Accordingly, the field-effect transistor containing the gate insulating layer can have excellent transistor characteristics (high mobility, high on/off ratio, low subthreshold swing, and Vth of around 0 V).

The present inventors have found that combination of the passivation layer and the gate insulating layer can realize excellent transistor characteristics (high mobility, high on/off ratio, low subthreshold swing, and Vth of around 0 V) and can maintain the excellent transistor characteristics even after a process for forming the passivation layer. Moreover, the present inventors have found that combination of the passivation layer and the gate insulating layer can realize smaller change in threshold voltage in a BTS test as compared with a case where the passivation layer contains the first complex oxide and the gate insulating layer does not contain the second complex oxide.

Accordingly, combination of the passivation layer and the gate insulating layer can provide a field-effect transistor having excellent TFT characteristics (high mobility, high on/off ratio, low subthreshold swing, and Vth of around 0 V), being capable of maintaining the excellent TFT characteristics even after a process for forming the passivation layer, having a small change of threshold voltage in a BTS test, and having high reliability.

The second complex oxide also contains at least one of Zr (zirconium) and Hf (hafnium). When the second complex oxide contains at least one of the Zr and the Hf, thermal stability, heat resistance, and denseness can be further improved.

Examples of the alkaline earth metal in the second complex oxide include Be (beryllium), Mg (magnesium), Ca (calcium), Sr (strontium), and Ba (barium). These alkaline earth metals may be used alone or in combination.

Examples of the rare-earth element in the second complex oxide include Sc (scandium), Y (yttrium), La (lanthanum), Ce (cerium), Pr (praseodymium), Nd (neodymium), Pm (promethium), Sm (samarium), Eu (europium), Gd (gadolinium), Tb (terbium), Dy (dysprosium), Ho (holmium), Er (erbium), Tm (thulium), Yb (ytterbium), and Lu (lutetium).

A compositional ratio between the alkaline earth metal and the rare-earth element in the second complex oxide is not particularly limited and may be appropriately selected depending on the intended purpose. However, the compositional ratio is preferably within the following range.

In the second complex oxide, the compositional ratio between the alkaline earth metal and the rare-earth element (the alkaline earth metal : the rare-earth element) is preferably from 10.0 mol% through 67.0 mol% : from 33.0 mol% through 90.0 mol% based on the amounts converted to the corresponding oxides (BeO, MgO, CaO, SrO, BaO, Sc₂O₃, Y₂O₃, La₂O₃, Ce₂O₃, Pr₂O₃, Nd₂O₃, Pm₂O₃, Sm₂O₃, Eu₂O₃, Gd₂O₃, Tb₂O₃, Dy₂O₃, Ho₂O₃, Er₂O₃, Tm₂O₃, Yb₂O₃, and Lu₂O₃).

A compositional ratio among the alkaline earth metal, the rare-earth element, and at least one of the Zr and the Hf in the second complex oxide is not particularly limited and may be appropriately selected depending on the intended purpose. However, the compositional ratio is preferably within the following range.

In the second complex oxide, the compositional ratio among the alkaline earth metal, the rare-earth element, and at least one of the Zr and the Hf (the alkaline earth metal: the rare-earth element: at least one of the Zr and the Hf) is preferably from 5.0 mol% through 22.0 mol% : from 33.0 mol% through 90.0 mol% : from 5.0 mol% through 45.0 mol% based on the amounts converted to the corresponding oxides (BeO, MgO, CaO, SrO, BaO, Sc₂O₃, Y₂O₃, La₂O₃, Ce₂O₃, Pr₂O₃, Nd₂O₃, Pm₂O₃, Sm₂O₃, Eu₂O₃, Gd₂O₃, Tb₂O₃, Dy₂O₃, Ho₂O₃, Er₂O₃, Tm₂O₃, Yb₂O₃, Lu₂O₃, ZrO₂, and HfO₂).

The ratios of the oxides (BeO, MgO, CaO, SrO, BaO, Sc₂O₃, Y₂O₃, La₂O₃, Ce₂O₃, Pr₂O₃, Nd₂O₃, Pm₂O₃, Sm₂O₃, Eu₂O₃, Gd₂O₃, Tb₂O₃, Dy₂O₃, Ho₂O₃, Er₂O₃, Tm₂O₃, Yb₂O₃, Lu₂O₃, ZrO₂, and HfO₂) in the second complex oxide can be calculated, for example, by analyzing a cationic element of the oxide through X-ray fluorescence spectrometry, electron probe microanalysis (EPMA), or inductively coupled plasma atomic emission spectroscopy (ICP-AES).

A dielectric constant of the gate insulating layer is not particularly limited and may be appropriately selected depending on the intended purpose.

The dielectric constant of the gate insulating layer can be measured, for example, by the same method as the measuring method of the dielectric constant of the passivation layer.

A linear expansion coefficient of the gate insulating layer is not particularly limited and may be appropriately selected depending on the intended purpose.

The linear expansion coefficient of the gate insulating layer can be measured, for example, by the same method as the measuring method of the linear expansion coefficient of the passivation layer.

### -Formation method of gate insulating layer-

A formation method of the gate insulating layer is not particularly limited and may be appropriately selected depending on the intended purpose. Examples of the formation method include a method of forming a film by a vacuum process, such as sputtering, pulsed laser deposition (PLD), chemical vapor deposition (CVD), or atomic layer deposition (ALD) and patterning the film through photolithography.

Moreover, the gate insulating layer can be formed by preparing a coating liquid containing a precursor of the second complex oxide (a gate-insulating-layer-coating liquid), coating or printing the coating liquid onto an object to be coated, and baking the resultant under appropriate conditions.

An average film thickness of the gate insulating layer is preferably from 10 nm through 1,000 nm, more preferably from 20 nm through 500 nm.

### --Gate-insulating-layer-coating liquid--

The gate-insulating-layer-coating liquid contains at least an alkaline-earth-metal-containing compound, a rare-earth-element-containing compound, and a solvent, preferably contains at least one of a zirconium-containing compound and a hafnium-containing compound, and further contains other components according to the necessity.

### ---Alkaline-earth-metal-containing compound---

Examples of the alkaline-earth-metal-containing compound include inorganic alkaline earth metal compounds and organic alkaline earth metal compounds. Examples of alkaline earth metals in the alkaline-earth-metal-containing compounds include Be (beryllium), Mg (magnesium), Ca (calcium), Sr (strontium), and Ba (barium).

Examples of the inorganic alkaline earth metal compounds include alkaline earth metal nitrate, alkaline earth metal sulfate, alkaline earth metal chlorides, alkaline earth metal fluorides, alkaline earth metal bromides, and alkaline earth metal iodides.

Examples of the alkaline earth metal nitrate include magnesium nitrate, calcium nitrate, strontium nitrate, and barium nitrate.

Examples of the alkaline earth metal sulfate include magnesium sulfate, calcium sulfate, strontium sulfate, and barium sulfate.

Examples of the alkaline earth metal chlorides include magnesium chloride, calcium chloride, strontium chloride, and barium chloride.

Examples of the alkaline earth metal fluorides include magnesium fluoride, calcium fluoride, strontium fluoride, and barium fluoride.

Examples of the alkaline earth metal bromides include magnesium bromide, calcium bromide, strontium bromide, and barium bromide.

Examples of the alkaline earth metal iodides include magnesium iodide, calcium iodide, strontium iodide, and barium iodide.

The organic alkaline earth metal compounds are not particularly limited and may be appropriately selected depending on the intended purpose, so long as the organic alkaline earth metal compounds are each a compound containing an alkaline earth metal and an organic group. The alkaline earth metal and the organic group are bonded, for example, via an ionic bond, a covalent bond, or a coordinate bond.

The organic group is not particularly limited and may be appropriately selected depending on the intended purpose. Examples of the organic group include alkyl groups which may have a substituent, alkoxy groups which may have a substituent, acyloxy groups which may have a substituent, phenyl groups which may have a substituent, acetyl acetonate groups which may have a substituent, and sulfonic acid groups which may have a substituent. Examples of the alkyl groups include alkyl groups containing from 1 through 6 carbon atoms. Examples of the alkoxy groups include alkoxy groups containing from 1 through 6 carbon atoms. Examples of the acyloxy groups include: acyloxy groups containing from 1 through 10 carbon atoms; acyloxy groups part of which is substituted with a benzene ring, such as benzoic acid; acyloxy groups part of which is substituted with a hydroxyl group, such as lactic acid; and acyloxy groups containing two or more carbonyl groups, such as oxalic acid and citric acid.

Examples of the organic alkaline earth metal compounds include magnesium methoxide, magnesium ethoxide, diethyl magnesium, magnesium acetate, magnesium formate, acetylacetone magnesium, magnesium 2-ethylhexanoate, magnesium lactate, magnesium naphthenate, magnesium citrate, magnesium salicylate, magnesium benzoate, magnesium oxalate, magnesium trifluromethanesulfonate, calcium methoxide, calcium ethoxide, calcium acetate, calcium formate, acetylacetone calcium, calcium dipivaloyl methanate, calcium 2-ethylhexanoate, calcium lactate, calcium naphthenate, calcium citrate, calcium salicylate, calcium neodecanoate, calcium benzoate, calcium oxalate, strontium isopropoxide, strontium acetate, strontium formate, acetylacetone strontium, strontium 2-ethylhexanoate, strontium lactate, strontium naphthenate, strontium salicylate, strontium oxalate, barium ethoxide, barium isopropoxide, barium acetate, barium formate, acetylacetone barium, barium 2-ethylhexanoate, barium lactate, barium naphthenate, barium neodecanoate, barium oxalate, barium benzoate, and barium trifluoromethane- sulfonate.

An amount of the alkaline-earth-metal-containing compound in the gate-insulating-layer-coating liquid is not particularly limited and may be appropriately selected depending on the intended purpose.

### ---Rare-earth-element-containing compound---

Examples of rare-earth elements in the rare-earth-element-containing compound include Sc (scandium), Y (yttrium), La (lanthanum), Ce (cerium), Pr (praseodymium), Nd (neodymium), Pm (promethium), Sm (samarium), Eu (europium), Gd (gadolinium), Tb (terbium), Dy (dysprosium), Ho (holmium), Er (erbium), Tm (thulium), Yb (ytterbium), and Lu (lutetium).

Examples of the rare-earth-element-containing compound include inorganic rare-earth compounds and organic rare-earth compounds.

Examples of the inorganic rare-earth compounds include rare-earth nitrate, rare-earth sulfate, rare-earth fluorides, rare-earth chlorides, rare-earth bromides, and rare-earth iodides.

Examples of the rare-earth nitrate include scandium nitrate, yttrium nitrate, lanthanum nitrate, cerium nitrate, praseodymium nitrate, neodymium nitrate, samarium nitrate, europium nitrate, gadolinium nitrate, terbium nitrate, dysprosium nitrate, holmium nitrate, erbium nitrate, thulium nitrate, ytterbium nitrate, and lutetium nitrate.

Examples of the rare-earth sulfate include scandium sulfate, yttrium sulfate, lanthanum sulfate, cerium sulfate, praseodymium sulfate, neodymium sulfate, samarium sulfate, europium sulfate, gadolinium sulfate, terbium sulfate, dysprosium sulfate, holmium sulfate, erbium sulfate, thulium sulfate, ytterbium sulfate, and lutetium sulfate.

Examples of the rare-earth fluorides include scandium fluoride, yttrium fluoride, lanthanum fluoride, cerium fluoride, praseodymium fluoride, neodymium fluoride, samarium fluoride, europium fluoride, gadolinium fluoride, terbium fluoride, dysprosium fluoride, holmium fluoride, erbium fluoride, thulium fluoride, ytterbium fluoride, and lutetium fluoride.

Examples of the rare-earth chlorides include scandium chloride, yttrium chloride, lanthanum chloride, cerium chloride, praseodymium chloride, neodymium chloride, samarium chloride, europium chloride, gadolinium chloride, terbium chloride, dysprosium chloride, holmium chloride, erbium chloride, thulium chloride, ytterbium chloride, and lutetium chloride.

Examples of the rare-earth bromides include scandium bromide, yttrium bromide, lanthanum bromide, praseodymium bromide, neodymium bromide, samarium bromide, europium bromide, gadolinium bromide, terbium bromide, dysprosium bromide, holmium bromide, erbium bromide, thulium bromide, ytterbium bromide, and lutetium bromide.

Examples of the rare-earth iodides include scandium iodide, yttrium iodide, lanthanum iodide, cerium iodide, praseodymium iodide, neodymium iodide, samarium iodide, europium iodide, gadolinium iodide, terbium iodide, dysprosium iodide, holmium iodide, erbium iodide, thulium iodide, ytterbium iodide, and lutetium iodide.

The organic rare-earth compounds are not particularly limited and may be appropriately selected depending on the intended purpose, so long as the organic rare-earth compounds are each a compound containing a rare-earth element and an organic group. The rare-earth element and the organic group are bonded, for example, via an ionic bond, a covalent bond, or a coordinate bond.

The organic group is not particularly limited and may be appropriately selected depending on the intended purpose. Examples of the organic group include alkyl groups which may have a substituent, alkoxy groups which may have a substituent, acyloxy groups which may have a substituent, acetyl acetonate groups which may have a substituent, and cyclopentadienyl groups which may have a substituent. Examples of the alkyl groups include alkyl groups containing from 1 through 6 carbon atoms. Examples of the alkoxy groups include alkoxy groups containing from 1 through 6 carbon atoms. Examples of the acyloxy groups include acyloxy groups containing from 1 through 10 carbon atoms.

Examples of the organic rare-earth compounds include scandium isopropoxide, scandium acetate, tris(cyclopentadienyl)scandium, yttrium isopropoxide, yttrium 2-ethylhexanoate, tris(acetylacetonato)yttrium, tris(cyclopentadienyl)yttrium, lanthanum isopropoxide, lanthanum 2-ethylhexanoate, tris(acetylacetonato)lanthanum, tris(cyclopentadienyl)lanthanum, cerium 2-ethylhexanoate, tris(acetylacetonato)cerium, tris(cyclopentadienyl)cerium, praseodymium isopropoxide, praseodymium oxalate, tris(acetylacetonato)praseodymium, tris(cyclopentadienyl)praseodymium, neodymium isopropoxide, neodymium 2-ethylhexanoate, neodymium trifluoroacetylacetonate, tris(isopropylcyclopentadienyl)neodymium, tris(ethylcyclopentadienyl)promethium, samarium isopropoxide, samarium 2-ethylhexanoate, tris(acetylacetonato)samarium, tris(cyclopentadienyl)samarium, europium 2-ethylhexanoate, tris(acetylacetonato)europium, tris(ethylcyclopentadienyl)europium, gadolinium isopropoxide, gadolinium 2-ethylhexanoate, tris(acetylacetonato)gadolinium, tris(cyclopentadienyl)gadolinium, terbium acetate, tris(acetylacetonato)terbium, tris(cyclopentadienyl)terbium, dysprosium isopropoxide, dysprosium acetate, tris(acetylacetonato)dysprosium, tris(ethylcyclopentadienyl)dysprosium, holmium isopropoxide, holmium acetate, tris(cyclopentadienyl)holmium, erbium isopropoxide, erbium acetate, tris(acetylacetonato)erbium, tris(cyclopentadienyl)erbium, thulium acetate, tris(acetylacetonato)thulium, tris(cyclopentadienyl)thulium, ytterbium isopropoxide, ytterbium acetate, tris(acetylacetonato)ytterbium, tris(cyclopentadienyl)ytterbium, lutetium oxalate, and tris(ethylcyclopentadienyl)lutetium.

An amount of the rare-earth-element-containing compound in the gate-insulating-layer-coating liquid is not particularly limited and may be appropriately selected depending on the intended purpose.

### ---Zirconium-containing compound---

Examples of the zirconium-containing compound include inorganic zirconium compounds and organic zirconium compounds.

Examples of the inorganic zirconium compounds include zirconium fluoride, zirconium chloride, zirconium bromide, zirconium iodide, zirconium carbonate, and zirconium sulfate.

The organic zirconium compounds are not particularly limited and may be appropriately selected depending on the intended purpose, so long as the organic zirconium compounds are each a compound containing zirconium and an organic group. The zirconium and the organic group are bonded, for example, via an ionic bond, a covalent bond, or a coordinate bond.

The organic group is not particularly limited and may be appropriately selected depending on the intended purpose. Examples of the organic group include alkyl groups which may have a substituent, alkoxy groups which may have a substituent, acyloxy groups which may have a substituent, acetylacetonate groups which may have a substituent, and cyclopentadienyl groups which may have a substituent. Examples of the alkyl groups include alkyl groups containing from 1 through 6 carbon atoms. Examples of the alkoxy groups include alkoxy groups containing from 1 through 6 carbon atoms. Examples of the acyloxy groups include acyloxy groups containing from 1 through 10 carbon atoms.

Examples of the organic zirconium compounds include zirconium butoxide, zirconium isopropoxide, zirconium oxide 2-ethylhexanoate, zirconium di(n-butoxide) bisacetylacetonate, tetrakis(acetylacetonate) zirconium, and tetrakis(cyclopentadienyl) zirconium.

An amount of the zirconium-containing compound in the gate-insulating-layer-coating liquid is not particularly limited and may be appropriately selected depending on the intended purpose.

### ---Hafnium-containing compound---

Examples of the hafnium-containing compound include inorganic hafnium compounds and organic hafnium compounds.

Examples of the inorganic hafnium compounds include hafnium fluoride, hafnium chloride, hafnium bromide, hafnium iodide, hafnium carbonate, and hafnium sulfate.

The organic hafnium compounds are not particularly limited and may be appropriately selected depending on the intended purpose, so long as the organic hafnium compounds are each a compound containing hafnium and an organic group. The hafnium and the organic group are bonded, for example, via an ionic bond, a covalent bond, or a coordinate bond.

The organic group is not particularly limited and may be appropriately selected depending on the intended purpose. Examples of the organic group include alkyl groups which may have a substituent, alkoxy groups which may have a substituent, acyloxy groups which may have a substituent, acetylacetonate groups which may have a substituent, and cyclopentadienyl groups which may have a substituent. Examples of the alkyl groups include alkyl groups containing from 1 through 6 carbon atoms. Examples of the alkoxy groups include alkoxy groups containing from 1 through 6 carbon atoms. Examples of the acyloxy groups include acyloxy groups containing from 1 through 10 carbon atoms.

Examples of the organic hafnium compounds include hafnium butoxide, hafnium isopropoxide, hafnium 2-ethylhexanoate, hafnium di(n-butoxide)bisacetylacetonate, tetrakis(acetylacetonate) hafnium, and bis(cyclopentadienyl)dimethyl hafnium.

An amount of the hafnium-containing compound in the gate-insulating-layer-coating liquid is not particularly limited and may be appropriately selected depending on the intended purpose.

### ---Solvent---

The solvent is not particularly limited and may be appropriately selected depending on the intended purpose, so long as the solvent is capable of stably dissolving or dispersing the above various compounds. Examples of the solvent include toluene, xylene, mesitylene, cymene, pentylbenzene, dodecylbenzene, bicyclohexyl, cyclohexylbenzene, decane, undecane, dodecane, tridecane, tetradecane, pentadecane, tetralin, decalin, isopropanol, ethyl benzoate, N,N-dimethylformamide, propylene carbonate, 2-ethyl hexanoate, mineral spirits, dimethylpropylene urea, 4-butyrolactone, 2-methoxy ethanol, and water.

An amount of the solvent in the gate-insulating-layer-coating liquid is not particularly limited and may be appropriately selected depending on the intended purpose.

A compositional ratio between the alkaline-earth-metal-containing compound and the rare-earth-element-containing compound (the alkaline-earth-metal-containing compound : the rare-earth-element-containing compound) in the gate-insulating-layer-coating liquid is not particularly limited and may be appropriately selected depending on the intended purpose. However, the compositional ratio is preferably within the following range.

In the gate-insulating-layer-coating liquid, the compositional ratio between the alkaline earth metal and the rare-earth element (the alkaline earth metal : the rare-earth element) is preferably from 10.0 mol% through 67.0 mol% : from 33.0 mol% through 90.0 mol% based on the amounts converted to the corresponding oxides (BeO, MgO, CaO, SrO, BaO, Sc₂O₃, Y₂O₃, La₂O₃, Ce₂O₃, Pr₂O₃, Nd₂O₃, Pm₂O₃, Sm₂O₃, Eu₂O₃, Gd₂O₃, Tb₂O₃, Dy₂O₃, Ho₂O₃, Er₂O₃, Tm₂O₃, Yb₂O₃, and Lu₂O₃).

A compositional ratio among the alkaline-earth-metal-containing compound, the rare-earth-element-containing compound, and at least one of the zirconium-containing compound and the hafnium-containing compound in the gate-insulating-layer-coating liquid (the alkaline-earth-metal-containing compound : the rare-earth-element-containing compound : at least one of the zirconium-containing compound and the hafnium-containing compound) is not particularly limited and may be appropriately selected depending on the intended purpose. However, the compositional ratio is preferably within the following range.

In the gate-insulating-layer-coating liquid, the compositional ratio among the alkaline earth metal, the rare-earth element, and at least one of the Zr and the Hf (the alkaline earth metal: the rare-earth element: at least one of the Zr and the Hf) is preferably from 5.0 mol% through 22.0 mol% : from 33.0 mol% through 90.0 mol% : from 5.0 mol% through 45.0 mol% based on the amounts converted to the corresponding oxides (BeO, MgO, CaO, SrO, BaO, Sc₂O₃, Y₂O₃, La₂O₃, Ce₂O₃, Pr₂O₃, Nd₂O₃, Pm₂O₃, Sm₂O₃, Eu₂O₃, Gd₂O₃, Tb₂O₃, Dy₂O₃, Ho₂O₃, Er₂O₃, Tm₂O₃, Yb₂O₃, Lu₂O₃, ZrO₂, and HfO₂).

### --Formation method of gate insulating layer using gate-insulating-layer-coating liquid--

One example of a formation method of the gate insulating layer using the gate-insulating-layer-coating liquid will be described. The formation method of the gate insulating layer contains a coating step and a heat treatment step and further contains other steps according to the necessity.

The coating step is not particularly limited and may be appropriately selected depending on the intended purpose, so long as the coating step is a step of coating the gate-insulating-layer-coating liquid onto an object to be coated. A method of the coating is not particularly limited and may be appropriately selected depending on the intended purpose. Examples of the method include: a method of forming a film through a solution process and patterning the film through photolithography; and a method of directly forming a film having a desired shape by printing, such as inkjet printing, nanoimprinting, or gravure printing. Examples of the solution process include dip coating, spin coating, die coating, and nozzle printing.

The heat treatment step is not particularly limited and may be appropriately selected depending on the intended purpose, so long as the heat treatment step is a step of heat-treating the gate-insulating-layer-coating liquid coated on the object to be coated. Note that, in the heat treatment step, the gate-insulating-layer-coating liquid coated on the object to be coated may be dried through air drying. As a result of the heat treatment, the solvent is evaporated and the second complex oxide is generated.

In the heat treatment step, evaporation of the solvent (hereinafter referred to as "evaporation treatment") and generation of the second complex oxide (hereinafter referred to as "generation treatment") are preferably performed at different temperatures. Specifically, it is preferable that after the evaporation of the solvent, the temperature be elevated to generate the second complex oxide. At the time of generation of the second complex oxide, for example, at least one of the alkaline-earth-metal-containing compound, the rare-earth-element-containing compound, the zirconium-containing compound, and the hafnium-containing compound is decomposed.

A temperature of the evaporation treatment is not particularly limited and may be appropriately selected depending on the solvent contained. For example, the temperature of the evaporation treatment is from 80°C through 180°C. As for the evaporation, it is effective to use a vacuum oven for reducing the required temperature. The time of the evaporation treatment is not particularly limited and may be appropriately selected depending on the intended purpose. For example, the time of the evaporation treatment is from 10 minutes through 1 hour.

A temperature of the generation treatment is not particularly limited and may be appropriately selected depending on the intended purpose. However, the temperature of the generation treatment is preferably 100°C or higher but lower than 550°C, more preferably from 200°C through 500°C. The time of the generation treatment is not particularly limited and may be appropriately selected depending on the intended purpose. For example, the time of the generation treatment is from 1 hour through 5 hours.

Note that, in the heat treatment step, the evaporation treatment and the generation treatment may be continuously performed or may be performed in a divided manner of a plurality of steps.

A method of the heat treatment is not particularly limited and may be appropriately selected depending on the intended purpose. Examples of the method of the heat treatment include a method of heating the object to be coated. An atmosphere in the heat treatment is not particularly limited and may be appropriately selected depending on the intended purpose. However, the atmosphere is preferably an oxygen atmosphere. When the heat treatment is performed in the oxygen atmosphere, decomposed products can be promptly discharged to the outside of the system and generation of the second complex oxide can be accelerated.

In the heat treatment, in view of acceleration of reaction of the generation treatment, it is effective to apply ultraviolet rays having a wavelength of 400 nm or shorter to the material after the evaporation treatment. Applying the ultraviolet rays having a wavelength of 400 nm or shorter can cleave chemical bonds of the organic material contained in the material after the evaporation treatment, and can decompose the organic material. Therefore, the second complex oxide can be efficiently formed. The ultraviolet rays having a wavelength of 400 nm or shorter are not particularly limited and may be appropriately selected depending on the intended purpose. Examples of the ultraviolet rays include ultraviolet rays having a wavelength of 222 nm emitted from an excimer lamp. It is also preferable to apply ozone instead of or in combination with the ultraviolet rays. Applying the ozone to the material after the evaporation treatment accelerates generation of the oxide.

### <Source electrode and drain electrode>

The source electrode and the drain electrode are not particularly limited and may be appropriately selected depending on the intended purpose, so long as the source electrode and the drain electrode are electrodes configured to take electric current out from the field-effect transistor.

The source electrode and the drain electrode are formed to be in contact with the gate insulating layer.

A material of the source electrode and the drain electrode is not particularly limited and may be appropriately selected depending on the intended purpose. Examples of the material include: metals (e.g., Mo, Al, Au, Ag, and Cu) and alloys of these metals; transparent conductive oxides, such as indium tin oxide (ITO) and antimony-doped tin oxide (ATO); and organic conductors, such as polyethylene dioxythiophene (PEDOT) and polyaniline (PANI).

### -Formation method of source electrode and drain electrode-

The formation method of the source electrode and the drain electrode is not particularly limited and may be appropriately selected depending on the intended purpose. Examples of the formation method include: (i) a method of forming a film through sputtering or dip coating and patterning the film through photolithography; and (ii) a method of directly forming a film having a desired shape through a printing process, such as inkjet printing, nanoimprinting, or gravure printing.

An average film thickness of the source electrode and the drain electrode is not particularly limited and may be appropriately selected depending on the intended purpose. However, the average film thickness is preferably from 20 nm through 1 µm, more preferably from 50 nm through 300 nm.

### <Semiconductor layer>

The semiconductor layer is formed at least between the source electrode and the drain electrode.

Here, the "between" means a position at which the semiconductor layer allows the field-effect transistor to function together with the source electrode and the drain electrode. The position of the semiconductor layer is not particularly limited and may be appropriately selected depending on the intended purpose, so long as the position is the above-described position.

The semiconductor layer is in contact with the gate insulating layer, the source electrode, and the drain electrode.

A material of the semiconductor layer is not particularly limited and may be appropriately selected depending on the intended purpose. Examples of the material include silicon semiconductors and oxide semiconductors.

Examples of the silicon conductors include amorphous silicon and polycrystalline silicon.

Examples of the oxide semiconductors include InGa-Zn-O, In-Zn-O, and In-Mg-O.

Among these examples, oxide semiconductors are preferable.

### -Formation method of semiconductor layer-

A formation method of the semiconductor layer is not particularly limited and may be appropriately selected depending on the intended purpose. Examples of the formation method include: a method of forming a film through a vacuum process (e.g., sputtering, pulsed laser deposition (PLD), chemical vapor deposition (CVD), or atomic layer deposition (ALD)) or a solution process (e.g., dip coating, spin coating, or die coating) and patterning the film through photolithography; and a method of directly forming a film having a desired shape through a printing method, such as inkjet printing, nanoimprinting, or gravure printing.

An average film thickness of the semiconductor layer is not particularly limited and may be appropriately selected depending on the intended purpose. However, the average film thickness of the semiconductor layer is preferably from 5 nm through 1 µm, more preferably from 10 nm through 0.5 µm.

### <Gate electrode>

The gate electrode is not particularly limited and may be appropriately selected depending on the intended purpose, so long as the gate electrode is an electrode configured to apply gate voltage to the field-effect transistor.

The gate electrode is in contact with the gate insulating layer and faces the semiconductor layer via the gate insulating layer.

A material of the gate electrode is not particularly limited and may be appropriately selected depending on the intended purpose. Examples of the material include: metals (e.g., Mo, Al, Au, Ag, and Cu) and alloys of these metals; transparent conductive oxides, such as indium tin oxide (ITO) and antimony-doped tin oxide (ATO); and organic conductors, such as polyethylene dioxythiophene (PEDOT) and polyaniline (PANI).

### -Formation method of gate electrode-

A formation method of the gate electrode is not particularly limited and may be appropriately selected depending on the intended purpose. Examples of the formation method include: (i) a method of forming a film through sputtering, or dip coating and patterning the film through photolithography; and (ii) a method of directly forming a film having a desired shape through a printing process, such as inkjet printing, nanoimprinting, or gravure printing.

An average film thickness of the gate electrode is not particularly limited and may be appropriately selected depending on the intended purpose. However, the average film thickness of the gate electrode is preferably from 20 nm through 1 µm, more preferably from 50 nm through 300 nm.

A structure of the field-effect transistor is not particularly limited and may be appropriately selected depending on the intended purpose. Examples of the structure of the field-effect transistor include the following structures:
(1) a field-effect transistor containing the substrate, the gate electrode formed on the substrate, the gate insulating layer formed on the gate electrode, the source electrode and the drain electrode formed on the gate insulating layer, the semiconductor layer formed between the source electrode and the drain electrode, and the passivation layer formed on the semiconductor layer; and
(2) a field-effect transistor containing the substrate, the source electrode and the drain electrode formed on the substrate, the semiconductor layer formed between the source electrode and the drain electrode, the gate insulating layer formed on the source electrode, the drain electrode, and the semiconductor layer, the gate electrode formed on the gate insulating layer, and the passivation layer formed on the gate electrode.

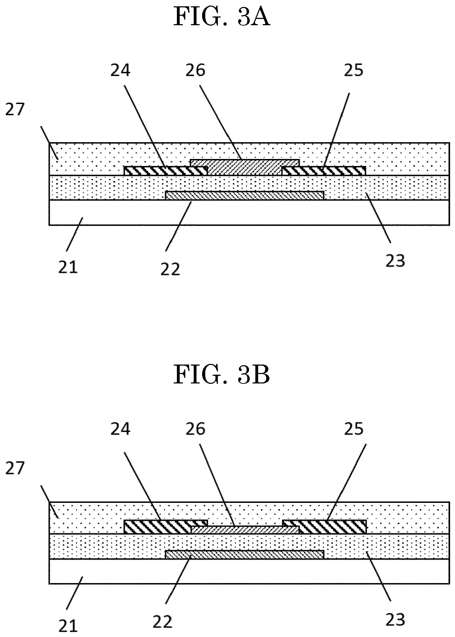

Examples of the field-effect transistor having the structure of (1) include a bottom contact/bottom gate field-effect transistor (FIG. 3A) and a top contact/bottom gate field-effect transistor (FIG. 3B).

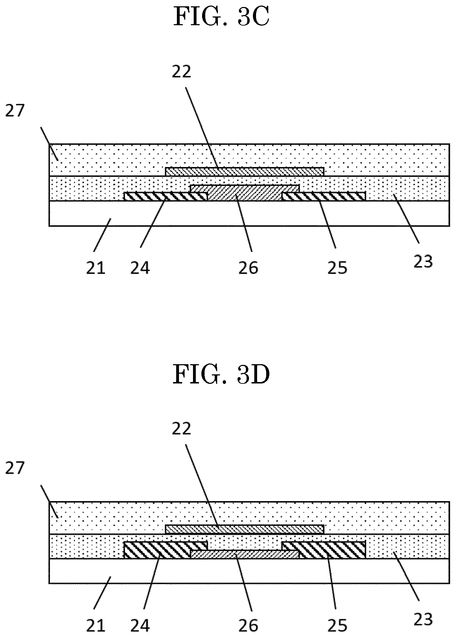

Examples of the field-effect transistor having the structure of (2) include a bottom contact/top gate field-effect transistor (FIG. 3C) and a top contact/top gate field-effect transistor (FIG. 3D).

In FIGs. 3A to 3D, reference numeral 21 denotes a substrate, 22 denotes a gate electrode, 23 denotes a gate insulating layer, 24 denotes a source electrode, 25 denotes a drain electrode, 26 denotes an oxide semiconductor layer, and 27 denotes a passivation layer.

The field-effect transistor is suitably used in the display element described below, but use of the field-effect transistor is not limited to the use in the display element. For example, the field-effect transistor can be used for IC cards and ID tags.

### (Display element)

A display element of the present disclosure contains at least a light control element and a driving circuit configured to drive the light control element and further contains other members according to the necessity.

### <Light control element>

The light control element is not particularly limited and may be appropriately selected depending on the intended purpose, so long as the light control element is an element configured to control light output according to a driving signal. Examples of the light control element include electroluminescent (EL) elements, electrochromic (EC) elements, liquid crystal elements, electrophoretic elements, and electrowetting elements.

### <Driving circuit>

The driving circuit is not particularly limited and may be appropriately selected depending on the intended purpose, so long as the driving circuit is a circuit containing the field-effect transistor of the present disclosure and configured to drive the light control element.

### <Other members>

The other members are not particularly limited and may be appropriately selected depending on the intended purpose.

Because the display element contains the field-effect transistor of the present disclosure, long service life and high-speed operation can be realized.

### (Image display device)

An image display device of the present disclosure contains at least a plurality of display elements, a plurality of wired lines, and a display control device and further contains other members according to the necessity.

The image display device is a device configured to display an image corresponding to image data.

### <Display elements>

The plurality of display elements are not particularly limited and may be appropriately selected depending on the intended purpose, so long as the plurality of display elements are the display elements of the present disclosure arranged in a matrix.

### <Wires>

The plurality of wired lines are not particularly limited and may be appropriately selected depending on the intended purpose, so long as the plurality of wired lines are wired lines configured to individually apply gate voltage to the field-effect transistors in the plurality of display elements.

### <Display control device>

The display control device is not particularly limited and may be appropriately selected depending on the intended purpose, so long as the display control device is a device configured to individually control the gate voltage of the field-effect transistors via the plurality of wired lines correspondingly to the image data.

### <Other members>

The other members are not particularly limited and may be appropriately selected depending on the intended purpose.

Because the image display device contains the display elements of the present disclosure, long service life and high-speed operation can be realized.

The image display device can be used as a display unit in mobile information devices (e.g., mobile phones, portable music players, portable video players, electronic books, and personal digital assistants (PDAs)) and camera devices (e.g., still cameras and video cameras). Moreover, the image display device can be used as a unit configured to display various pieces of information in transportation systems (e.g., cars, aircraft, trains, and ships). Furthermore, the image display device can be used as a unit configured to display various pieces of information in measuring devices, analysis devices, medical equipment, and advertising media.

### (System)

A system of the present disclosure contains at least the image display device of the present disclosure and an image-data-generating device.

The image-data-generating device is a device configured to generate image data based on image information to be displayed and to output the image data to the image display device.

The display element, the image display device, and the system of the present disclosure will next be described with reference to the drawings.

First, a television device will be described as one example of the system of the present disclosure.

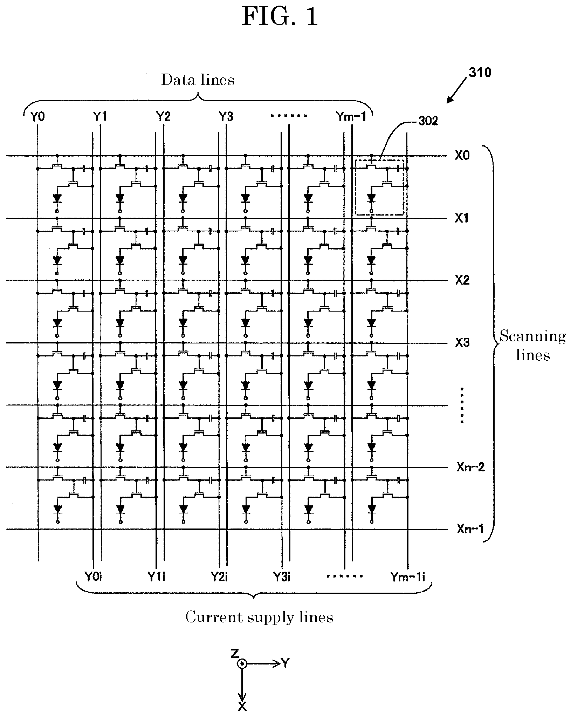

For example, the television device as one example of the system of the present disclosure can have the structure described in the paragraphs [0038] to [0058] and FIG. 1 in Japanese Unexamined Patent Application Publication No. 2010-074148.

Next, the image display device of the present disclosure will be described.

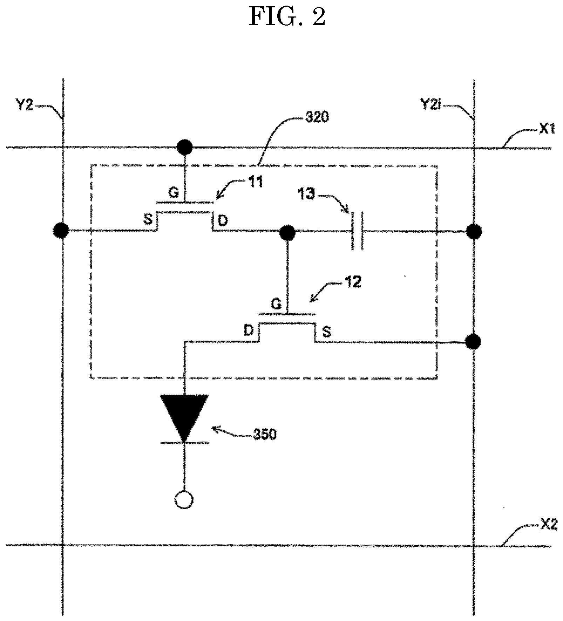

For example, the image display device of the present disclosure can have the structure described in the paragraphs [0059] and [0060] and FIGs. 2 and 3 in Japanese Unexamined Patent Application Publication No. 2010-074148.

Next, the display element of the present disclosure will be described with reference to the drawings.

FIG. 1 illustrates a display 310 in which display elements are arranged in a matrix.

As illustrated in FIG. 1, the display 310 contains "n" scanning lines (X0, X1, X2, X3, ... Xn-2, Xn-1) arranged along the X axis direction at constant intervals, "m" data lines (Y0, Y1, Y2, Y3, ... Ym-1) arranged along the Y axis direction at constant intervals, and "m" current supply lines (Y0i, Y1i, Y2i, Y3i, ... Ym-1i) arranged along the Y axis direction at constant intervals.

Each of the display elements can be identified by each of the scanning lines and each of the data lines.

FIG. 2 is a schematic diagram illustrating one example of the display element of the present disclosure.

As illustrated as one example in FIG. 2, the display element contains an organic electroluminescent (EL) element 350 and a drive circuit 320 configured to emit light from the organic EL element 350. Specifically, the display 310 is an organic EL display of a so-called active matrix system. The display 310 is a 32-inch color display. Note that, a size of the display is not limited to this size.

The drive circuit 320 of FIG. 2 will be described.

The drive circuit 320 contains two field-effect transistors 11 and 12 and a capacitor 13.

The field-effect transistor 11 operates as a switching element. A gate electrode G is coupled to a predetermined scanning line and a source electrode S is coupled to a predetermined data line. Moreover, a drain electrode D is coupled to one terminal of the capacitor 13.

The capacitor 13 is configured to memorize the state of the field-effect transistor 11; i.e., data. The other terminal of the capacitor 13 is coupled to a predetermined current supply line.

The field-effect transistor 12 is configured to supply large electric current to the organic EL element 350. A gate electrode G is coupled to a drain electrode D of the field-effect transistor 11. A drain electrode D is coupled to an anode of the organic EL element 350 and a source electrode S is coupled to a predetermined current supply line.

When the field-effect transistor 11 turns into the state of "On", the organic EL element 350 is driven by the field-effect transistor 12.

As illustrated as one example in FIG. 3A, the field-effect transistors 11 and 12 each contain a substrate 21, a gate electrode 22, a gate insulating layer 23, a source electrode 24, a drain electrode 25, an oxide semiconductor layer 26, and a passivation layer 27.

The field-effect transistors 11 and 12 can be formed with the materials and by the processes mentioned in the descriptions of the field-effect transistor of the present disclosure.

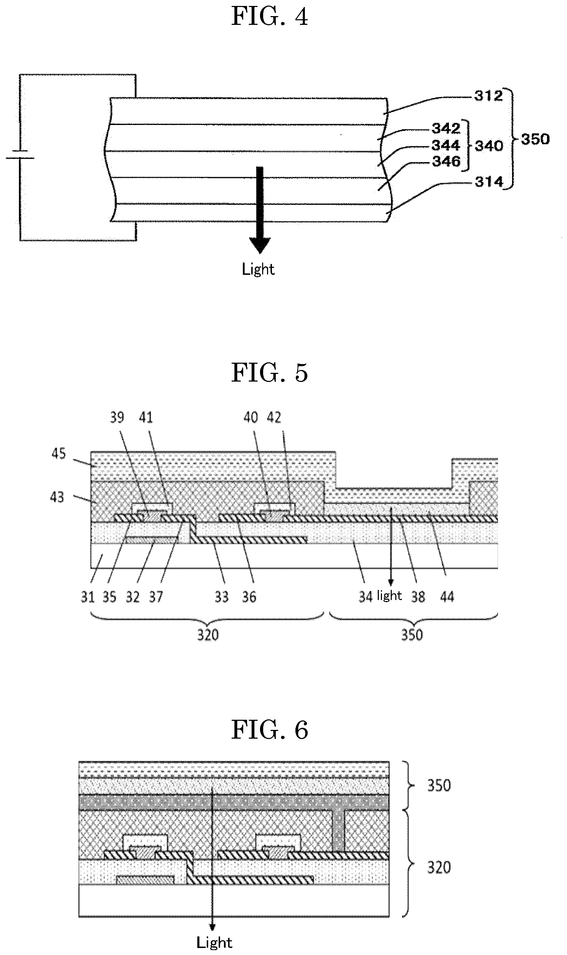

FIG. 4 is a schematic structural view illustrating one example of an organic EL element.

In FIG. 4, the organic EL element 350 contains a cathode 312, an anode 314, and an organic EL thin film layer 340.

A material of the cathode 312 is not particularly limited and may be appropriately selected depending on the intended purpose. Examples of the material include aluminium (Al), magnesium (Mg)-silver (Ag) alloy, aluminium (Al)-lithium (Li) alloy, and indium tin oxide (ITO). Note that, the magnesium (Mg)-silver (Ag) alloy becomes a high-reflective electrode if having a sufficient thickness, and an extremely thin film (less than about 20 nm) of the Mg-Ag alloy becomes a semi-transparent electrode. In FIG. 4, light is taken out from the side of the anode, but light can be taken out from the side of the cathode by making the cathode as a transparent or semi-transparent electrode.

A material of the anode 314 is not particularly limited and may be appropriately selected depending on the intended purpose. Examples of the material include indium tin oxide (ITO), indium zinc oxide (IZO), and silver (Ag)-neodymium (Nd) alloy. Note that, in the case where a silver alloy is used, the resultant electrode becomes a high-reflective electrode, which is suitable for taking light out from the side of the cathode.

The organic EL thin film layer 340 contains an electron transporting layer 342, a light emitting layer 344, and a hole transporting layer 346. The electron transporting layer 342 is coupled to a cathode 312, and the hole transporting layer 346 is coupled to an anode 314. The light emitting layer 344 emits light, when a predetermined voltage is applied between the anode 314 and the cathode 312.

Here, the electron transporting layer 342 and the light emitting layer 344 may form a single layer. Moreover, an electron injecting layer may be disposed between the electron transporting layer 342 and the cathode 312. Furthermore, a hole injecting layer may be disposed between the hole transporting layer 346 and the anode 314.

The above-described light control element in FIG. 4 is a so-called "bottom emission" organic EL element, in which light is taken out from the side of the substrate. However, the light control element may be a "top emission" organic EL element, in which light is taken out from the opposite side to the substrate.

FIG. 5 illustrates one example of a display element combining an organic EL element 350 and a drive circuit 320.

The display element contains a substrate 31, first and second gate electrodes 32 and 33, a gate insulating layer 34, first and second source electrodes 35 and 36, first and second drain electrodes 37 and 38, first and second oxide semiconductor layers 39 and 40, first and second passivation layers 41 and 42, and an interlayer insulating layer 43, an organic EL layer 44, and a cathode 45. The first drain electrode 37 and the second gate electrode 33 are coupled to each other via a through-hole formed in the gate insulating layer 34.

For the sake of convenience, FIG. 5 is drawn as if the capacitor was formed between the second gate electrode 33 and the second drain electrode 38. In actual, the position of the capacitor formed is not limited and a capacitor having a necessary capacity can be appropriately designed at a necessary position.

In the display element of FIG. 5, the second drain electrode 38 functions as an anode of the organic EL element 350.

The substrate 31, the first and second gate electrodes 32 and 33, the gate insulating layer 34, the first and second source electrodes 35 and 36, the first and second drain electrodes 37 and 38, the first and second oxide semiconductor layers 39 and 40, and the first and second passivation layers 41 and 42 can be formed with the materials and by the processes mentioned in the descriptions of the field-effect transistor of the present disclosure.

Note that, the first passivation layer 41 and the second passivation layer 42 each correspond to the passivation layer of the field-effect transistor of the present disclosure. The gate insulating layer 34 corresponds to the gate insulating layer of the field-effect transistor of the present disclosure.

A material of the interlayer insulating layer 43 (planarization layer) is not particularly limited and may be appropriately selected depending on the intended purpose. Examples of the material include organic materials, inorganic materials, and organic-inorganic composite materials.

Examples of the organic materials include: resins, such as polyimide, acrylic resins, fluororesins, non-fluororesins, olefin resins, and silicone resins; and photosensitive resins using these resins.

Examples of the inorganic materials include spin-on-glass (SOG) materials, such as AQUAMICA, available from AZ Electronic Materials.

Examples of the organic-inorganic composite materials include the organic-inorganic composite compounds containing a silane compound disclosed in Japanese Unexamined Patent Application Publication No. 2007-158146.

The interlayer insulating layer preferably has barrier properties against moisture, oxygen, and hydrogen contained in the atmosphere.

A formation process of the interlayer insulating layer is not particularly limited and may be appropriately selected depending on the intended purpose. Examples of the formation process include: a method of directly forming a film having a desired shape through spin coating, inkjet printing, slit coating, nozzle printing, gravure printing, or dip coating; and a method of patterning a photosensitive material through photolithography.

It is effective to perform a heat treatment as a post treatment after the formation of the interlayer insulating layer to stabilize characteristics of the field-effect transistor constituting the display element.

Production methods of the organic EL layer 44 and the cathode 45 are not particularly limited and may be appropriately selected depending on the intended purpose. Examples of the production methods include: vacuum film forming methods (e.g., vacuum deposition and sputtering); and solution processes (e.g., inkjet printing and nozzle coating).

With these methods, it is possible to produce a display element which is a so-called "bottom emission" organic EL element where emitted light is taken out from the side of the substrate. In this case, the substrate 31, the gate insulating layer 34, and the second drain electrode (anode) 38 are required to be transparent.

In FIG. 5, the structure where the organic EL element 350 is disposed next to the drive circuit 320 has been described. However, as illustrated in FIG. 6, the structure of the display element may be a structure where the organic EL element 350 is disposed above the drive circuit 320. Also in this case, the organic EL element is a so-called "bottom emission" organic EL element where emitted light is taken out from the side of the substrate, and therefore the drive circuit 320 is required to be transparent. As for the source electrode and the drain electrode or the anode, preferably used are conductive transparent oxides, such as ITO, In₂O₃, SnO₂, ZnO, Ga-doped ZnO, Al-doped ZnO, and Sb-doped SnO₂.

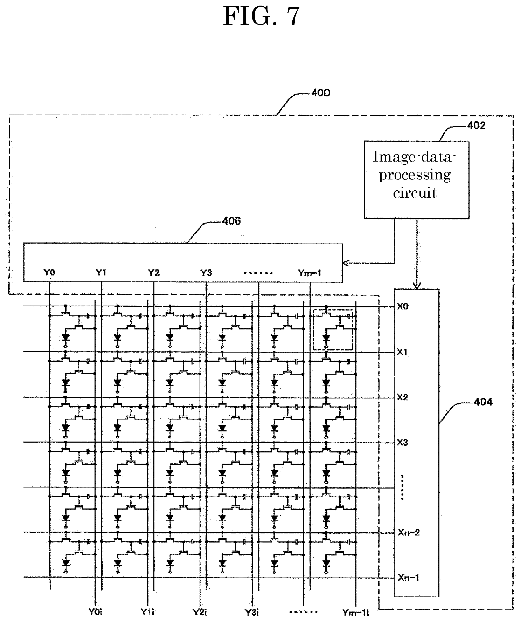

As illustrated as one example in FIG. 7, the display control device 400 contains an image-data-processing circuit 402, a scanning-line-driving circuit 404, and a data-line-driving circuit 406.

The image-data-processing circuit 402 determines brightness of a plurality of display elements 302 in the display 310 based on output signals of the image output circuit.

The scanning-line-driving circuit 404 individually applies voltage to "n" scanning lines according to the instructions of the image-data-processing circuit 402.

The data-line-driving circuit 406 individually applies voltage to "m" data lines according to the instructions of the image-data-processing circuit 402.

Note that, the above embodiment refers to a case where the organic EL thin film layer contains an electron transporting layer, a light emitting layer, and a hole transporting layer, but this embodiment is not limitative. For example, an electron transporting layer and a light emitting layer may be combined as a single layer. Moreover, an electron injecting layer may be disposed between the electron transporting layer and the cathode. Furthermore, a hole injecting layer may be disposed between the hole transporting layer and the anode.

The above embodiment refers to a so-called "bottom emission" organic EL element where emitted light is taken out from the side of the substrate, but this embodiment is not limitative. For example, light may be taken out from the opposite side of the substrate by using a high-reflective electrode (e.g., a silver (Ag)-neodymium (Nd) alloy electrode) as the anode 314 and using a semi-transparent electrode (e.g., a magnesium (Mg)-silver (Ag) alloy electrode) or a transparent electrode (e.g., an ITO electrode) as the cathode 312.

The above embodiment refers to a case where the light control element is an organic EL element, but this embodiment is not limitative. For example, the light control element may be an electrochromic element. In this case, the display 310 is an electrochromic display.

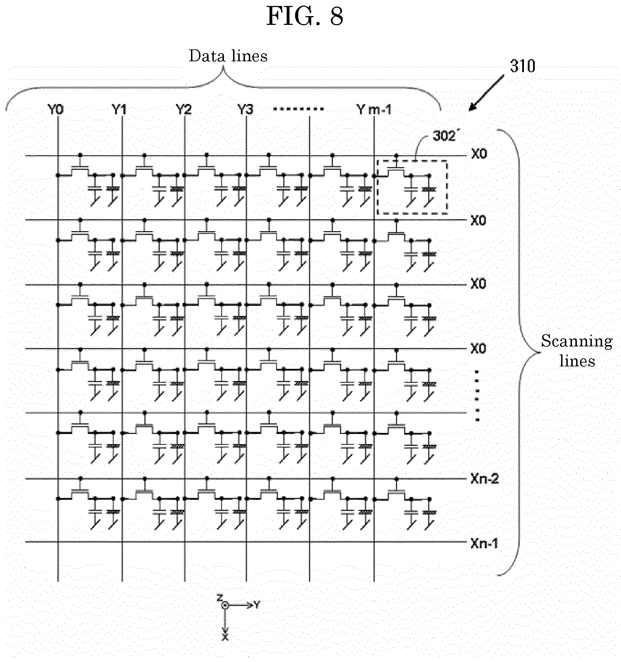

The light control element may be a liquid crystal element. In this case, the display 310 is a liquid crystal display. As illustrated as one example in FIG. 8, it is not necessary to provide a current supply line for a display element 302'.

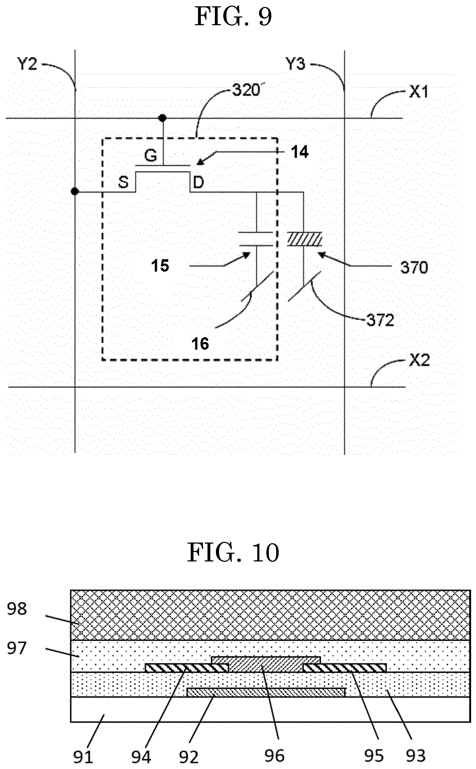

Alternatively, as illustrated as one example in FIG. 9, a drive circuit 320' may be produced with one field-effect transistor 14, which is similar to each of the field-effect transistors (11 and 12), and a capacitor 15. In the field-effect transistor 14, a gate electrode G is coupled to a predetermined scanning line and a source electrode S is coupled to a predetermined data line. Moreover, a drain electrode D is coupled to a pixel electrode of a liquid crystal element 370 and the capacitor 15. Note that, in FIG. 9, referential numerals 16 and 372 each denote a counter electrode (common electrode) of the liquid crystal element 370.

In the above embodiment, the light control element may be an electrophoretic element. Moreover, the light control element may be an electrowetting element.

The above embodiment refers to a case where the display is a color display, but this embodiment is not limitative.

Note that, the field-effect transistor according to the present embodiment can also be used for products other than the display elements (e.g., IC cards and ID tags).

The display element, the image display device, and the system each using the field-effect transistor of the present disclosure achieve high-speed operations and a long service life.

### Examples

The present disclosure will next be described by way of Examples, but the Examples should not be construed to limit the present disclosure in any way. In the Examples below, the unit "%" denotes "% by mass", unless otherwise specified.

### (Example 1)

### <Production of field-effect transistor>

### -Preparation of passivation-layer-coating liquid-

In 1 mL of toluene, 0.32 g of scandium(III) tris(2,2,6,6-tetramethyl-3,5-heptanedionate)hydrate (SIGMA-ALDRICH 517607, available from SIGMA-ALDRICH CO., LLC.) and 0.07 mL of a 2-ethylhexanoic acid solution of calcium 2-ethylhexanoate (Ca content: from 3% through 8%, Alfa36657, available from Alfa Aesar) were mixed, to obtain a passivation-layer-coating liquid. A first complex oxide formed with the passivation-layer-coating liquid would have the composition as presented in Table 1-1.

### -Preparation of gate-insulating-layer-coating liquid-

In 1 mL of toluene, 0.25 g of samarium acetylacetonate trihydrate (Strem 93-6226, available from Strem Chemicals Inc.) and 0.05 mL of a toluene solution of magnesium 2-ethylhexanoate (Mg content: 3%, Strem 12-1260, available from Strem Chemicals Inc.) were mixed, to obtain a gate-insulating-layer-coating liquid. A second complex oxide formed with the gate-insulating-layer-coating liquid would have the composition as presented in Table 1-1.

Next, a bottom contact/bottom gate field-effect transistor as illustrated in FIG. 10 was produced.

### -Formation of gate electrode-

First, a gate electrode 92 was formed on a glass substrate (substrate 91). Specifically, an Al (aluminium) alloy film was formed on the glass substrate (substrate 91) by DC sputtering so as to have an average film thickness of about 100 nm. Thereafter, a photoresist was coated on the Al alloy film, and the resultant was subjected to prebake, exposure by an exposing device, and developing, to form a resist pattern having the same pattern as a pattern of the gate electrode 92 to be formed. Moreover, resist-pattern-free regions of the Al alloy film were removed by etching with a phosphoric acetic nitric acid (PAN)-based etching solution. Thereafter, the resist pattern was also removed to form the gate electrode 92 formed of the Al alloy film.

### -Formation of gate insulating layer-

Next, 0.4 mL of the gate-insulating-layer-coating liquid was dropped and spin-coated on the substrate under predetermined conditions (the substrate was rotated at 500 rpm for 5 seconds and then at 3,000 rpm for 20 seconds, and the rotation was stopped so as to be 0 rpm in 5 seconds). Subsequently, the resultant was subjected to an evaporation treatment in the atmosphere at 120°C for 1 hour, then baking in the O₂ atmosphere at 400°C for 3 hours, and then annealing in the atmosphere at 500°C for 1 hour, to form a second-complex-oxide film as a gate insulating layer 93. The average film thickness of the gate insulating layer was about 110 nm.

### -Formation of source electrode and drain electrode-

Next, a source electrode 94 and a drain electrode 95 were formed on the gate insulating layer 93. Specifically, an Al (aluminium) alloy film was formed on the gate insulating layer 93 by DC sputtering so as to have an average film thickness of about 100 nm. Thereafter, a photoresist was coated on the Al alloy film, and the resultant was subjected to prebake, exposure by an exposing device, and developing, to form a resist pattern having the same pattern as a pattern of the source electrode 94 and the drain electrode 95 to be formed. Moreover, resist-pattern-free regions of the Al alloy film were removed by RIE. Thereafter, the resist pattern was also removed to form the source electrode 94 and the drain electrode 95, each of which was formed of the Al alloy film.

### -Formation of oxide semiconductor layer-

Next, an oxide semiconductor layer 96 was formed. Specifically, a Mg-In based oxide (In₂MgO₄) film was formed by DC sputtering so as to have an average film thickness of about 100 nm. Thereafter, a photoresist was coated on the Mg-In based oxide film, and the resultant was subjected to prebake, exposure by an exposing device, and developing, to form a resist pattern having the same pattern as a pattern of the oxide semiconductor layer 96 to be formed. Moreover, resist-pattern-free regions of the Mg-In based oxide film were removed by wet etching. Thereafter, the resist pattern was also removed to form the oxide semiconductor layer 96. As a result, the oxide semiconductor layer 96 was formed in a manner that a channel was formed between the source electrode 94 and the drain electrode 95.

### -Formation of passivation layer-

Next, 0.4 mL of the passivation-layer-coating liquid was dropped and spin-coated on the substrate under predetermined conditions (the substrate was rotated at 1,000 rpm for 5 seconds and then at 3,000 rpm for 20 seconds, and the rotation was stopped so as to be 0 rpm in 5 seconds). Subsequently, the resultant was subjected to an evaporation treatment in the atmosphere at 120°C for 1 hour and then baking in the O₂ atmosphere at 400°C for 3 hours, to form a first-complex-oxide film as a passivation layer 97. The average film thickness of the passivation layer was 135 nm.

### -Formation of interlayer insulating layer-

Next, an interlayer insulating layer 98 was formed. Specifically, a positive photosensitive organic-inorganic composite material (ADEKA Nonahybrid Silicone FX series, available from ADEKA CORPORATION) was spin-coated on the passivation layer 97, and the resultant was subjected to prebake, exposure by an exposing device, and developing, to obtain a desired pattern. Thereafter, the resultant was post-baked at 150°C for 1 hour and then at 200°C for 1 hour.

Finally, the resultant was subjected to a heat treatment at 230°C for 1 hour as a heating treatment of a post treatment, to complete a field-effect transistor. The average film thickness of the interlayer insulating layer was about 1,500 nm.

### (Example 2)

### <Production of field-effect transistor>

### -Preparation of passivation-layer-coating liquid-

In 1 mL of toluene, 1.14 mL of a toluene solution of lanthanum 2-ethylhexanoate (La content: 7%, Wako 122-03371, available from Wako Chemical, Ltd.), 0.01 mL of a toluene solution of magnesium 2-ethylhexanoate (Mg content: 3%, Strem 12-1260, available from Strem Chemicals Inc.), and 0.15 mL of a toluene solution of strontium 2-ethylhexanoate (Sr content: 2%, Wako 195-09561, available from Wako Chemical, Ltd.) were mixed, to obtain a passivation-layer-coating liquid. A first complex oxide formed with the passivation-layer-coating liquid would have the composition as presented in Table 1-1.

### -Preparation of gate-insulating-layer-coating liquid-

In 1 mL of toluene, 0.17 g of scandium(III) tris(2,2,6,6-tetramethyl-3,5-heptanedionate)hydrate (SIGMA-ALDRICH 517607, available from SIGMA-ALDRICH CO., LLC.), 0.11 g of yttrium 2-ethylhexanoate (Strem 39-2400, available from Strem Chemicals Inc.), and 0.09 mL of a 2-ethylhexanoic acid solution of calcium 2-ethylhexanoate (Ca content: from 3% through 8%, Alfa36657, available from Alfa Aesar) were mixed, to obtain a gate-insulating-layer-coating liquid. A second complex oxide formed with the gate-insulating-layer-coating liquid would have the composition as presented in Table 1-1.

A field-effect transistor was produced in the same manner as in Example 1, except that the thus-prepared passivation-layer-coating liquid and the thus-prepared gate-insulating-layer-coating liquid were used.

### (Example 3)

### <Production of field-effect transistor>

### -Preparation of passivation-layer-coating liquid-

In 1 mL of toluene, 0.26 mL of a toluene solution of gadolinium 2-ethylhexanoate (Gd content: 25%, Strem 64-3500, available from Strem Chemicals Inc.) and 0.36 mL of a toluene solution of barium 2-ethylhexanoate (Ba content: 8%, Wako 021-09471, available from Wako Chemical, Ltd.) were mixed, to obtain a passivation-layer-coating liquid. A first complex oxide formed with the passivation-layer-coating liquid would have the composition as presented in Table 1-1.

### -Preparation of gate-insulating-layer-coating liquid-

In 1 mL of toluene, 1.10 mL of a toluene solution of lanthanum 2-ethylhexanoate (La content: 7%, Wako 122-03371, available from Wako Chemical, Ltd.) and 0.30 mL of a toluene solution of strontium 2-ethylhexanoate (Sr content: 2%, Wako 195-09561, available from Wako Chemical, Ltd.) were mixed, to obtain a gate-insulating-layer-coating liquid. A second complex oxide formed with the gate-insulating-layer-coating liquid would have the composition as presented in Table 1-1.

A field-effect transistor was produced in the same manner as in Example 1, except that the thus-prepared passivation-layer-coating liquid and the thus-prepared gate-insulating-layer-coating liquid were used.

### (Example 4)

### <Production of field-effect transistor>

### -Preparation of passivation-layer-coating liquid-

In 1 mL of toluene, 0.26 mL of a 2-ethylhexanoic acid solution of neodymium 2-ethylhexanoate (Nd content: 12%, Strem 60-2400, available from Strem Chemicals Inc.), 0.15 g of ytterbium acetylacetonate trihydrate (Strem 70-2202, available from Strem Chemicals Inc.), 0.29 mL of a toluene solution of strontium 2-ethylhexanoate (Sr content: 2%, Wako 195-09561, available from Wako Chemical, Ltd.), and 0.01 mL of a mineral spirit solution of zirconium oxide 2-ethylhexanoate (Zr content: 12%, Wako 269-01116, available from Wako Chemical, Ltd.) were mixed, to obtain a passivation-layer-coating liquid. A first complex oxide formed with the passivation-layer-coating liquid would have the composition as presented in Table 1-1.

### -Preparation of gate-insulating-layer-coating liquid-

In 1 mL of toluene, 0.30 mL of a toluene solution of gadolinium 2-ethylhexanoate (Gd content: 25%, Strem 64-3500, available from Strem Chemicals Inc.) and 0.26 mL of a toluene solution of barium 2-ethylhexanoate (Ba content: 8%, Wako 021-09471, available from Wako Chemical, Ltd.) were mixed, to obtain a gate-insulating-layer-coating liquid. A second complex oxide formed with the gate-insulating-layer-coating liquid would have the composition as presented in Table 1-1.

A field-effect transistor was produced in the same manner as in Example 1, except that the thus-prepared passivation-layer-coating liquid and the thus-prepared gate-insulating-layer-coating liquid were used.

### (Example 5)

### <Production of field-effect transistor>

### -Preparation of passivation-layer-coating liquid-

In 1 mL of toluene, 0.23 g of dysprosium acetylacetonate trihydrate (Strem 66-2002, available from Strem Chemicals Inc.), 0.03 mL of a 2-ethylhexanoic acid solution of calcium 2-ethylhexanoate (Ca content: from 3% through 8%, Alfa36657, available from Alfa Aesar), 0.05 mL of a toluene solution of barium 2-ethylhexanoate (Ba content: 8%, Wako 021-09471, available from Wako Chemical, Ltd.), and 0.05 mL of a 2-ethylhexanoic acid solution of hafnium 2-ethylhexanoate (Gelest AKH332, available from Gelest, Inc.) were mixed, to obtain a passivation-layer-coating liquid. A first complex oxide formed with the passivation-layer-coating liquid would have the composition as presented in Table 1-1.

### -Preparation of gate-insulating-layer-coating liquid-

In 1 mL of toluene, 0.30 g of yttrium 2-ethylhexanoate (Strem 39-2400, available from Strem Chemicals Inc.) and 0.19 mL of a toluene solution of strontium 2-ethylhexanoate (Sr content: 2%, Wako 195-09561, available from Wako Chemical, Ltd.) were mixed, to obtain a gate-insulating-layer-coating liquid. A second complex oxide formed with the gate-insulating-layer-coating liquid would have the composition as presented in Table 1-1.

A field-effect transistor was produced in the same manner as in Example 1, except that the thus-prepared passivation-layer-coating liquid and the thus-prepared gate-insulating-layer-coating liquid were used.

### (Example 6)

### <Production of field-effect transistor>

### -Preparation of passivation-layer-coating liquid-

In 1 mL of toluene, 1.11 mL of a toluene solution of lanthanum 2-ethylhexanoate (La content: 7%, Wako 122-03371, available from Wako Chemical, Ltd.), 0.02 mL of a 2-ethylhexanoic acid solution of calcium 2-ethylhexanoate (Ca content: from 3% through 8%, Alfa36657, available from Alfa Aesar), 0.03 mL of a mineral spirit solution of zirconium oxide 2-ethylhexanoate (Zr content: 12%, Wako 269-01116, available from Wako Chemical, Ltd.), and 0.01 mL of a 2-ethylhexanoic acid solution of hafnium 2-ethylhexanoate (Gelest AKH332, available from Gelest, Inc.) were mixed, to obtain a passivation-layer-coating liquid. A first complex oxide formed with the passivation-layer-coating liquid would have the composition as presented in Table 1-2.

### -Preparation of gate-insulating-layer-coating liquid-

In 1 mL of toluene, 0.29 g of europium 2-ethylhexanoate (Strem 93-6311, available from Strem Chemicals Inc.), 0.08 mL of a toluene solution of magnesium 2-ethylhexanoate (Mg content: 3%, Strem 12-1260, available from Strem Chemicals Inc.), and 0.03 mL of a 2-ethylhexanoic acid solution of calcium 2-ethylhexanoate (Ca content: from 3% through 8%, Alfa36657, available from Alfa Aesar) were mixed, to obtain a gate-insulating-layer-coating liquid. A second complex oxide formed with the gate-insulating-layer-coating liquid would have the composition as presented in Table 1-2.

A field-effect transistor was produced in the same manner as in Example 1, except that the thus-prepared passivation-layer-coating liquid and the thus-prepared gate-insulating-layer-coating liquid were used.

### (Example 7)

### <Production of field-effect transistor>

### -Preparation of passivation-layer-coating liquid-

In 1 mL of toluene, 0.32 g of scandium(III) tris(2,2,6,6-tetramethyl-3,5-heptanedionate)hydrate (SIGMA-ALDRICH 517607, available from SIGMA-ALDRICH CO., LLC.), 0.06 mL of a toluene solution of magnesium 2-ethylhexanoate (Mg content: 3%, Strem 12-1260, available from Strem Chemicals Inc.), and 0.02 mL of a mineral spirit solution of zirconium oxide 2-ethylhexanoate (Zr content: 12%, Wako 269-01116, available from Wako Chemical, Ltd.) were mixed, to obtain a passivation-layer-coating liquid. A first complex oxide formed with the passivation-layer-coating liquid would have the composition as presented in Table 1-2.

### -Preparation of gate-insulating-layer-coating liquid-

In 1 mL of toluene, 0.19 mL of a toluene solution of gadolinium 2-ethylhexanoate (Gd content: 25%, Strem 64-3500, available from Strem Chemicals Inc.), 0.09 g of ytterbium acetylacetonate trihydrate (Strem 70-2202, available from Strem Chemicals Inc.), and 0.55 mL of a toluene solution of strontium 2-ethylhexanoate (Sr content: 2%, Wako 195-09561, available from Wako Chemical, Ltd.) were mixed, to obtain a gate-insulating-layer-coating liquid. A second complex oxide formed with the gate-insulating-layer-coating liquid would have the composition as presented in Table 1-2.

A field-effect transistor was produced in the same manner as in Example 1, except that the thus-prepared passivation-layer-coating liquid and the thus-prepared gate-insulating-layer-coating liquid were used.

### (Example 8)

### <Production of field-effect transistor>

### -Preparation of passivation-layer-coating liquid-

In 1 mL of toluene, 0.23 g of yttrium 2-ethylhexanoate (Strem 39-2400, available from Strem Chemicals Inc.) and 0.82 mL of a toluene solution of strontium 2-ethylhexanoate (Sr content: 2%, Wako 195-09561, available from Wako Chemical, Ltd.) were mixed, to obtain a passivation-layer-coating liquid. A first complex oxide formed with the passivation-layer-coating liquid would have the composition as presented in Table 1-2.

### -Preparation of gate-insulating-layer-coating liquid-

In 1 mL of toluene, 0.21 g of samarium acetylacetonate trihydrate (Strem 93-6226, available from Strem Chemicals Inc.), 0.04 mL of a 2-ethylhexanoic acid solution of calcium 2-ethylhexanoate (Ca content: from 3% through 8%, Alfa36657, available from Alfa Aesar), and 0.09 mL of a mineral spirit solution of zirconium oxide 2-ethylhexanoate (Zr content: 12%, Wako 269-01116, available from Wako Chemical, Ltd.) were mixed, to obtain a gate-insulating-layer-coating liquid. A second complex oxide formed with the gate-insulating-layer-coating liquid would have the composition as presented in Table 1-2.

A field-effect transistor was produced in the same manner as in Example 1, except that the thus-prepared passivation-layer-coating liquid and the thus-prepared gate-insulating-layer-coating liquid were used.

### (Example 9)

### <Production of field-effect transistor>

### -Preparation of passivation-layer-coating liquid-

In 1 mL of toluene, 0.23 g of ytterbium acetylacetonate trihydrate (Strem 70-2202, available from Strem Chemicals Inc.), 0.08 mL of a toluene solution of magnesium 2-ethylhexanoate (Mg content: 3%, Strem 12-1260, available from Strem Chemicals Inc.), and 0.03 mL of a 2-ethylhexanoic acid solution of calcium 2-ethylhexanoate (Ca content: from 3% through 8%, Alfa36657, available from Alfa Aesar) were mixed, to obtain a passivation-layer-coating liquid. A first complex oxide formed with the passivation-layer-coating liquid would have the composition as presented in Table 1-2.

### -Preparation of gate-insulating-layer-coating liquid-

In 1 mL of toluene, 1.06 mL of a toluene solution of lanthanum 2-ethylhexanoate (La content: 7%, Wako 122-03371, available from Wako Chemical, Ltd.), 0.06 mL of a toluene solution of barium 2-ethylhexanoate (Ba content: 8%, Wako 021-09471, available from Wako Chemical, Ltd.), and 0.04 mL of a 2-ethylhexanoic acid solution of hafnium 2-ethylhexanoate (Gelest AKH332, available from Gelest, Inc.) were mixed, to obtain a gate-insulating-layer-coating liquid. A second complex oxide formed with the gate-insulating-layer-coating liquid would have the composition as presented in Table 1-2.

A field-effect transistor was produced in the same manner as in Example 1, except that the thus-prepared passivation-layer-coating liquid and the thus-prepared gate-insulating-layer-coating liquid were used.

### (Example 10)

### <Production of field-effect transistor>

### -Preparation of passivation-layer-coating liquid-

In 1 mL of toluene, 0.40 mL of a 2-ethylhexanoic acid solution of neodymium 2-ethylhexanoate (Nd content: 12%, Strem 60-2400, available from Strem Chemicals Inc.), 0.09 g of dysprosium acetylacetonate trihydrate (Strem 66-2002, available from Strem Chemicals Inc.), and 0.46 mL of a toluene solution of strontium 2-ethylhexanoate (Sr content: 2%, Wako 195-09561, available from Wako Chemical, Ltd.) were mixed, to obtain a passivation-layer-coating liquid. A first complex oxide formed with the passivation-layer-coating liquid would have the composition as presented in Table 1-2.

### -Preparation of gate-insulating-layer-coating liquid-

In 1 mL of toluene, 0.32 mL of a toluene solution of gadolinium 2-ethylhexanoate (Gd content: 25%, Strem 64-3500, available from Strem Chemicals Inc.), 0.01 mL of a toluene solution of magnesium 2-ethylhexanoate (Mg content: 3%, Strem 12-1260, available from Strem Chemicals Inc.), 0.06 mL of a mineral spirit solution of zirconium oxide 2-ethylhexanoate (Zr content: 12%, Wako 269-01116, available from Wako Chemical, Ltd.), and 0.02 mL of a 2-ethylhexanoic acid solution of hafnium 2-ethylhexanoate (Gelest AKH332, available from Gelest, Inc.) were mixed, to obtain a gate-insulating-layer-coating liquid. A second complex oxide formed with the gate-insulating-layer-coating liquid would have the composition as presented in Table 1-2.

A field-effect transistor was produced in the same manner as in Example 1, except that the thus-prepared passivation-layer-coating liquid and the thus-prepared gate-insulating-layer-coating liquid were used.

### (Example 11)

### <Production of field-effect transistor>

### -Preparation of passivation-layer-coating liquid-

In 1 mL of toluene, 0.23 g of scandium(III) tris(2,2,6,6-tetramethyl-3,5-heptanedionate)hydrate (SIGMA-ALDRICH 517607, available from SIGMA-ALDRICH CO., LLC.) and 0.40 mL of a toluene solution of barium 2-ethylhexanoate (Ba content: 8%, Wako 021-09471, available from Wako Chemical, Ltd.) were mixed, to obtain a passivation-layer-coating liquid. A first complex oxide formed with the passivation-layer-coating liquid would have the composition as presented in Table 1-3.

### -Preparation of gate-insulating-layer-coating liquid-

In 1 mL of toluene, 0.33 g of europium 2-ethylhexanoate (Strem 93-6311, available from Strem Chemicals Inc.), 0.02 mL of a 2-ethylhexanoic acid solution of calcium 2-ethylhexanoate (Ca content: from 3% through 8%, Alfa36657, available from Alfa Aesar), and 0.16 mL of a toluene solution of strontium 2-ethylhexanoate (Sr content: 2%, Wako 195-09561, available from Wako Chemical, Ltd.) were mixed, to obtain a gate-insulating-layer-coating liquid. A second complex oxide formed with the gate-insulating-layer-coating liquid would have the composition as presented in Table 1-3.

A field-effect transistor was produced in the same manner as in Example 1, except that the thus-prepared passivation-layer-coating liquid and the thus-prepared gate-insulating-layer-coating liquid were used.

### (Example 12)

### <Production of field-effect transistor>

### -Preparation of passivation-layer-coating liquid-

In 1 mL of toluene, 0.99 mL of a toluene solution of lanthanum 2-ethylhexanoate (La content: 7%, Wako 122-03371, available from Wako Chemical, Ltd.), 0.27 mL of a toluene solution of strontium 2-ethylhexanoate (Sr content: 2%, Wako 195-09561, available from Wako Chemical, Ltd.), and 0.05 mL of a mineral spirit solution of zirconium oxide 2-ethylhexanoate (Zr content: 12%, Wako 269-01116, available from Wako Chemical, Ltd.) were mixed, to obtain a passivation-layer-coating liquid. A first complex oxide formed with the passivation-layer-coating liquid would have the composition as presented in Table 1-3.

### -Preparation of gate-insulating-layer-coating liquid-

In 1 mL of toluene, 0.99 mL of a toluene solution of lanthanum 2-ethylhexanoate (La content: 7%, Wako 122-03371, available from Wako Chemical, Ltd.), 0.27 mL of a toluene solution of strontium 2-ethylhexanoate (Sr content: 2%, Wako 195-09561, available from Wako Chemical, Ltd.), and 0.05 mL of a mineral spirit solution of zirconium oxide 2-ethylhexanoate (Zr content: 12%, Wako 269-01116, available from Wako Chemical, Ltd.) were mixed, to obtain a gate-insulating-layer-coating liquid. A second complex oxide formed with the gate-insulating-layer-coating liquid would have the composition as presented in Table 1-3.

A field-effect transistor was produced in the same manner as in Example 1, except that the thus-prepared passivation-layer-coating liquid and the thus-prepared gate-insulating-layer-coating liquid were used.

### (Example 13)

### <Production of field-effect transistor>

### -Preparation of passivation-layer-coating liquid-

In 1 mL of toluene, 1.02 mL of a toluene solution of lanthanum 2-ethylhexanoate (La content: 7%, Wako 122-03371, available from Wako Chemical, Ltd.), 0.03 mL of a toluene solution of magnesium 2-ethylhexanoate (Mg content: 3%, Strem 12-1260, available from Strem Chemicals Inc.), 0.03 mL of a mineral spirit solution of zirconium oxide 2-ethylhexanoate (Zr content: 12%, Wako 269-01116, available from Wako Chemical, Ltd.), and 0.03 mL of a 2-ethylhexanoic acid solution of hafnium 2-ethylhexanoate (Gelest AKH332, available from Gelest, Inc.) were mixed, to obtain a passivation-layer-coating liquid. A first complex oxide formed with the passivation-layer-coating liquid would have the composition as presented in Table 1-3.

### -Preparation of gate-insulating-layer-coating liquid-

In 1 mL of toluene, 0.22 g of scandium(III) tris(2,2,6,6-tetramethyl-3,5-heptanedionate)hydrate (SIGMA-ALDRICH 517607, available from SIGMA-ALDRICH CO., LLC.), 0.08 g of yttrium 2-ethylhexanoate (Strem 39-2400, available from Strem Chemicals Inc.), 0.03 mL of a 2-ethylhexanoic acid solution of calcium 2-ethylhexanoate (Ca content: from 3% through 8%, Alfa36657, available from Alfa Aesar), and 0.05 mL of a mineral spirit solution of zirconium oxide 2-ethylhexanoate (Zr content: 12%, Wako 269-01116, available from Wako Chemical, Ltd.) were mixed, to obtain a gate-insulating-layer-coating liquid. A second complex oxide formed with the gate-insulating-layer-coating liquid would have the composition as presented in Table 1-3.

A field-effect transistor was produced in the same manner as in Example 1, except that the thus-prepared passivation-layer-coating liquid and the thus-prepared gate-insulating-layer-coating liquid were used.

### (Example 14)

### <Production of field-effect transistor>

### -Preparation of passivation-layer-coating liquid-

In 1 mL of toluene, 0.46 mL of a 2-ethylhexanoic acid solution of neodymium 2-ethylhexanoate (Nd content: 12%, Strem 60-2400, available from Strem Chemicals Inc.), 0.08 g of dysprosium acetylacetonate trihydrate (Strem 66-2002, available from Strem Chemicals Inc.), 0.02 mL of a 2-ethylhexanoic acid solution of calcium 2-ethylhexanoate (Ca content: from 3% through 8%, Alfa36657, available from Alfa Aesar), 0.01 mL of a toluene solution of barium 2-ethylhexanoate (Ba content: 8%, Wako 021-09471, available from Wako Chemical, Ltd.), and 0.02 mL of a 2-ethylhexanoic acid solution of hafnium 2-ethylhexanoate (Gelest AKH332, available from Gelest, Inc.) were mixed, to obtain a passivation-layer-coating liquid. A first complex oxide formed with the passivation-layer-coating liquid would have the composition as presented in Table 1-3.

### -Preparation of gate-insulating-layer-coating liquid-

In 1 mL of toluene, 0.24 g of europium 2-ethylhexanoate (Strem 93-6311, available from Strem Chemicals Inc.), 0.07 mL of a toluene solution of barium 2-ethylhexanoate (Ba content: 8%, Wako 021-09471, available from Wako Chemical, Ltd.), and 0.12 mL of a 2-ethylhexanoic acid solution of hafnium 2-ethylhexanoate (Gelest AKH332, available from Gelest, Inc.) were mixed, to obtain a gate-insulating-layer-coating liquid. A second complex oxide formed with the gate-insulating-layer-coating liquid would have the composition as presented in Table 1-3.

A field-effect transistor was produced in the same manner as in Example 1, except that the thus-prepared passivation-layer-coating liquid and the thus-prepared gate-insulating-layer-coating liquid were used.

### (Example 15)

### <Production of field-effect transistor>

### -Preparation of passivation-layer-coating liquid-

In 1 mL of toluene, 0.29 g of yttrium 2-ethylhexanoate (Strem 39-2400, available from Strem Chemicals Inc.), 0.03 mL of a 2-ethylhexanoic acid solution of calcium 2-ethylhexanoate (Ca content: from 3% through 8%, Alfa36657, available from Alfa Aesar), and 0.02 mL of a mineral spirit solution of zirconium oxide 2-ethylhexanoate (Zr content: 12%, Wako 269-01116, available from Wako Chemical, Ltd.) were mixed, to obtain a passivation-layer-coating liquid. A first complex oxide formed with the passivation-layer-coating liquid would have the composition as presented in Table 1-3.

### -Preparation of gate-insulating-layer-coating liquid-

In 1 mL of toluene, 1.04 mL of a toluene solution of lanthanum 2-ethylhexanoate (La content: 7%, Wako 122-03371, available from Wako Chemical, Ltd.), 0.09 mL of a toluene solution of strontium 2-ethylhexanoate (Sr content: 2%, Wako 195-09561, available from Wako Chemical, Ltd.), 0.03 mL of a mineral spirit solution of zirconium oxide 2-ethylhexanoate (Zr content: 12%, Wako 269-01116, available from Wako Chemical, Ltd.), and 0.03 mL of a 2-ethylhexanoic acid solution of hafnium 2-ethylhexanoate (Gelest AKH332, available from Gelest, Inc.) were mixed, to obtain a gate-insulating-layer-coating liquid. A second complex oxide formed with the gate-insulating-layer-coating liquid would have the composition as presented in Table 1-3.

A field-effect transistor was produced in the same manner as in Example 1, except that the thus-prepared passivation-layer-coating liquid and the thus-prepared gate-insulating-layer-coating liquid were used.

### (Comparative Example 1)

### <Production of field-effect transistor>

First, a gate electrode was produced on a glass substrate in the same manner as in Example 1.

### -Formation of gate insulating layer-

A SiON layer was formed as a gate insulating layer on the substrate and the gate electrode by RF sputtering using SiO₂ as a target material in an atmosphere containing oxygen, argon, and nitrogen. The average film thickness of the gate insulating layer formed in this manner was about 300 nm.

Next, a source electrode and a drain electrode, and an oxide semiconductor layer were formed on the gate insulating layer in the same manner as in Example 1.

### -Formation of passivation layer-

Next, a SiON layer was formed as a passivation layer over the substrate by RF sputtering using SiO₂ as a target material in an atmosphere containing oxygen, argon, and nitrogen. The average film thickness of the passivation layer formed in this manner was about 300 nm.

### -Formation of interlayer insulating layer-

Finally, an interlayer insulating layer was formed on the passivation layer, and a heat treatment as a post treatment was performed in the same manner as in Example 1, to complete a field-effect transistor.

### (Comparative Example 2)

### <Production of field-effect transistor>

### -Preparation of gate-insulating-layer-coating liquid-

In 1 mL of toluene, 0.32 g of europium 2-ethylhexanoate (Strem 93-6311, available from Strem Chemicals Inc.) and 0.12 mL of a toluene solution of barium 2-ethylhexanoate (Ba content: 8%, Wako 021-09471, available from Wako Chemical, Ltd.) were mixed, to obtain a gate-insulating-layer-coating liquid. A second complex oxide formed with the gate-insulating-layer-coating liquid would have the composition as presented in Table 2.

First, a gate electrode was produced on a glass substrate in the same manner as in Example 1.

### -Formation of gate insulating layer-

Next, a gate insulating layer was formed in the same manner as in Example 1, except that the thus-prepared gate-insulating-layer-coating liquid was used.

Next, a source electrode and a drain electrode, and an oxide semiconductor layer were formed on the gate insulating layer in the same manner as in Example 1.

### -Formation of passivation layer-

Next, a SiON layer was formed as a passivation layer over the substrate by RF sputtering using SiO₂ as a target material in an atmosphere containing oxygen, argon, and nitrogen. The average film thickness of the passivation layer formed in this manner was about 300 nm.

### -Formation of interlayer insulating layer-

Finally, an interlayer insulating layer was formed on the passivation layer and the resultant was subjected to a heat treatment as a post treatment in the same manner as in Example 1, to complete a field-effect transistor.

**Table 1-1**

| | | Ex. 1 | Ex. 2 | Ex. 3 | Ex. 4 | Ex. 5 |
|---|---|---|---|---|---|---|
| | Oxide | Ratios by mole of oxides | Ratios by mole of oxides | Ratios by mole of oxides | Ratios by mole of oxides | Ratios by mole of oxides |
| | | mol% | mol% | mol% | mol% | mol% |
| First complex oxide | Sc₂O₃ | 75 | | | | |
| | Y₂O₃ | | | | | |
| | La₂O₃ | | 85 | | | |
| | Nd₂O₃ | | | | 30.3 | |
| | Sm₂O₃ | | | | | |
| | Eu₂O₃ | | | | | |
| | Gd₂O₃ | | | 50 | | |
| | Dy₂O₃ | | | | | 66.6 |
| | Yb₂O₃ | | | | 45.5 | |
| | MgO | | 5 | | | |
| | CaO | 25 | | | | 8.2 |
| | SrO | | 10 | | 18.8 | |
| | BaO | | | 50 | | 8.5 |
| | ZrO₂ | | | | 5.4 | |
| | HfO₂ | | | | | 16.7 |
| | Total | 100 | 100 | 100 | 100 | 100 |
| Second complex oxide | Sc₂O₃ | | 40 | | | |
| | Y₂O₃ | | 30 | | | 87.3 |
| | La₂O₃ | | | 80 | | |
| | Nd₂O₃ | | | | | |
| | Sm₂O₃ | 83 | | | | |
| | Eu₂O₃ | | | | | |
| | Gd₂O₃ | | | | 60.5 | |
| | Dy₂O₃ | | | | | |
| | Yb₂O₃ | | | | | |
| | MgO | 17 | | | | |
| | CaO | | 30 | | | |
| | SrO | | | 20 | | 12.7 |
| | BaO | | | | 39.5 | |
| | ZrO₂ | | | | | |
| | HfO₂ | | | | | |
| | Total | 100 | 100 | 100 | 100 | 100 |

**Table 1-2**

| | | Ex. 6 | Ex. 7 | Ex. 8 | Ex. 9 | Ex. 10 |
|---|---|---|---|---|---|---|
| | Oxide | Ratios by mole of oxides | Ratios by mole of oxides | Ratios by mole of oxides | Ratios by mole of oxides | Ratios by mole of oxides |
| | | mol% | mol% | mol% | mol% | mol% |
| First complex oxide | Sc₂O₃ | | 74.2 | | | |
| | Y₂O₃ | | | 54 | | |
| | La₂O₃ | 80.9 | | | | |
| | Nd₂O₃ | | | | | 45.6 |
| | Sm₂O₃ | | | | | |
| | Eu₂O₃ | | | | | |
| | Gd₂O₃ | | | | | |
| | Dy₂O₃ | | | | | 25.8 |
| | Yb₂O₃ | | | | 66.6 | |
| | MgO | | 18.5 | | 24 | |
| | CaO | 5.8 | | | 9.4 | |
| | SrO | | | 46 | | 28.6 |
| | BaO | | | | | |
| | ZrO₂ | 10.5 | 7.3 | | | |
| | HfO₂ | 2.8 | | | | |
| | Total | 100 | 100 | 100 | 100 | 100 |
| Second complex oxide | Sc₂O₃ | | | | | |
| | Y₂O₃ | | | | | |
| | La₂O₃ | | | | 75.3 | |
| | Nd₂O₃ | | | | | |
| | Sm₂O₃ | | | 58.5 | | |
| | Eu₂O₃ | 65.4 | | | | |
| | Gd₂O₃ | | 40.2 | | | 67.5 |
| | Dy₂O₃ | | | | | |
| | Yb₂O₃ | | 26.5 | | | |
| | MgO | 25.9 | | | | 3 |
| | CaO | 8.7 | | 11.4 | | |
| | SrO | | 33.3 | | | |
| | BaO | | | | 10 | |
| | ZrO₂ | | | 30.1 | | 20.8 |
| | HfO₂ | | | | 14.7 | 8.7 |
| | Total | 100 | 100 | 100 | 100 | 100 |

**Table 1-3**

| | | Ex. 11 | Ex. 12 | Ex. 13 | Ex. 14 | Ex. 15 |
|---|---|---|---|---|---|---|
| | Oxide | Ratios by mole of oxides | Ratios by mole of oxides | Ratios by mole of oxides | Ratios by mole of oxides | Ratios by mole of oxides |
| | | mol% | mol% | mol% | mol% | mol% |
| First complex oxide | Sc₂O₃ | 45.5 | | | | |
| | Y₂O₃ | | | | | 80.7 |
| | La₂O₃ | | 66.6 | 70.2 | | |
| | Nd₂O₃ | | | | 55.5 | |
| | Sm₂O₃ | | | | | |
| | Eu₂O₃ | | | | | |
| | Gd₂O₃ | | | | | |
| | Dy₂O₃ | | | | 25.3 | |
| | Yb₂O₃ | | | | | |
| | MgO | | | 8.5 | | |
| | CaO | | | | 7.5 | 10.1 |
| | SrO | | 16.7 | | | |
| | BaO | 54.5 | | | 2.2 | |
| | ZrO₂ | | 16.7 | 10 | | 9.2 |
| | HfO₂ | | | 11.3 | 9.5 | |
| | Total | 100 | 100 | 100 | 100 | 100 |
| Second complex oxide | Sc₂O₃ | | | 50.3 | | |
| | Y₂O₃ | | | 22 | | |
| | La₂O₃ | | 66.6 | | | 73 |
| | Nd₂O₃ | | | | | |
| | Sm₂O₃ | | | | | |
| | Eu₂O₃ | 83.3 | | | 49.5 | |
| | Gd₂O₃ | | | | | |
| | Dy₂O₃ | | | | | |
| | Yb₂O₃ | | | | | |
| | MgO | | | | | |
| | CaO | 5.9 | | 10.9 | | |
| | SrO | 10.8 | 16.7 | | | 5.5 |
| | BaO | | | | 10 | |
| | ZrO₂ | | 16.7 | 16.8 | | 10.8 |
| | HfO₂ | | | | 40.5 | 10.7 |
| | Total | 100 | 100 | 100 | 100 | 100 |

**Table 2**

| | | Comp. Ex. 1 | Comp. Ex. 2 |
|---|---|---|---|
| | Oxide | Ratios by mole of oxides | Ratios by mole of oxides |
| | | mol% | mol% |
| | SiO₂ | | |
| | SiON | 100 | 100 |
| | Sc₂O₃ | | |
| | Y₂O₃ | | |
| | La₂O₃ | | |
| | Nd₂O₃ | | |
| | Sm₂O₃ | | |
| | Eu₂O₃ | | |
| First complex oxide | Gd₂O₃ | | |
| | Dy₂O₃ | | |
| | Yb₂O₃ | | |
| | MgO | | |
| | CaO | | |
| | SrO | | |
| | BaO | | |
| | ZrO₂ | | |
| | HfO₂ | | |
| | Total | 100 | 100 |
| | SiO₂ | | |
| | SiON | 100 | |
| | Sc₂O₃ | | |
| | Y₂O₃ | | |
| | La₂O₃ | | |
| | Nd₂O₃ | | |
| | Sm₂O₃ | | |
| | Eu₂O₃ | | 80 |
| Second complex oxide | Gd₂O₃ | | |
| | Dy₂O₃ | | |
| | Yb₂O₃ | | |
| | MgO | | |
| | CaO | | |
| | SrO | | |
| | BaO | | 20 |
| | ZrO₂ | | |
| | HfO₂ | | |
| | Total | 100 | 100 |

### <Evaluation of transistor characteristics of field-effect transistors>

Transistor characteristics of each of the field-effect transistors produced in Examples 1 to 15 and Comparative Examples 1 and 2 were evaluated before and after the formation of the passivation layer. The transistor characteristics were evaluated by measuring a relationship (Vgs-Ids) between the voltage (Vgs) between the gate electrode 92 and the source electrode 94 and the current (Ids) between the drain electrode 95 and the source electrode 94, when the voltage between the drain electrode 95 and the source electrode 94 (Vds) was +10 V.

Moreover, a field-effect mobility in a saturated region was calculated from the evaluation result of the transistor characteristics (Vgs-Ids). An Ids ratio (on/off ratio) of an on-state (e.g., Vgs = +10 V) to an off-state (e.g., Vgs = -10 V) of the transistor was calculated. A subthreshold swing (SS) was calculated as an index for sharpness of the rise of Ids upon the application of Vgs. Furthermore, threshold voltage (Vth) was calculated as a voltage vale at the time of the rise of Ids upon the application of Vgs.

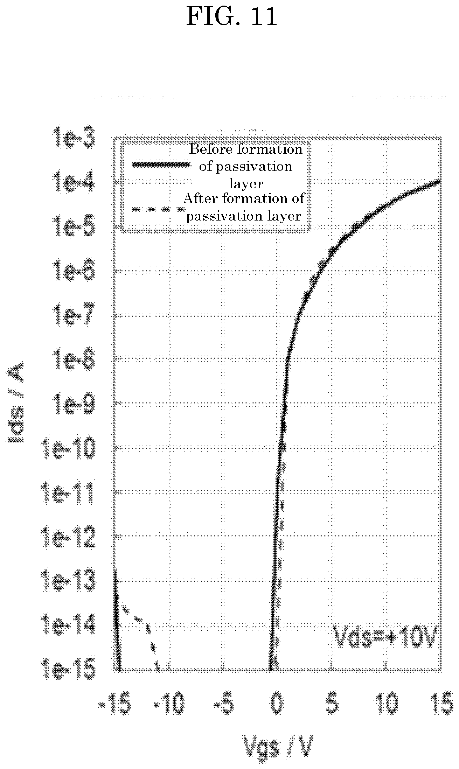

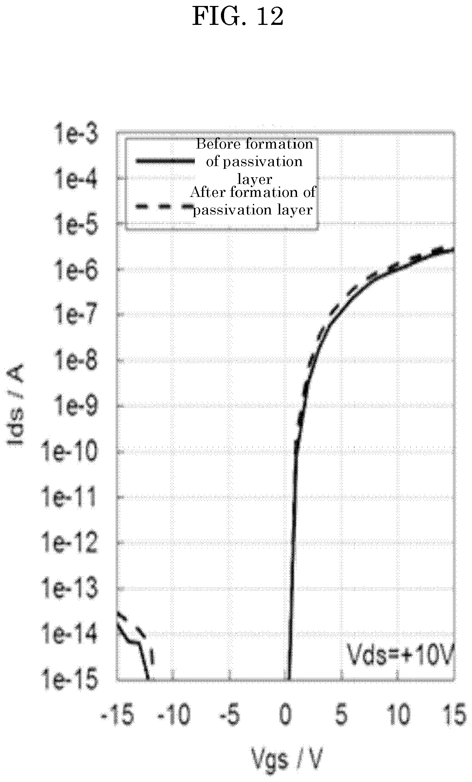

FIG. 11 presents the results of the transistor characteristics (Vgs-Ids) of the field-effect transistor produced in Example 12 before and after the formation of the passivation layer. FIG. 12 presents the results of the transistor characteristics (Vgs-Ids) of the field-effect transistor produced in Comparative Example 1 before and after the formation of the passivation layer. Table 3 presents the mobility, the on/off ratio, the subthreshold swing, and the Vth calculated from the transistor characteristics of each of the field-effect transistors produced in Examples 1 to 15 and Comparative Examples 1 and 2 before and after the formation of the passivation layer. In the results of the transistor characteristics described below, the following results: the mobility is high, the on/off ratio is high, the subthreshold swing is low, and the Vth is around 0 V, are expressed as excellent transistor characteristics. Specifically, when the mobility is 8 cm²/Vs or greater, the on/off ratio is 5.0 × 10⁸ or greater, the subthreshold swing is 0.5 or less, and Vth is within a range of ±5 V, the results are expressed as excellent transistor characteristics.

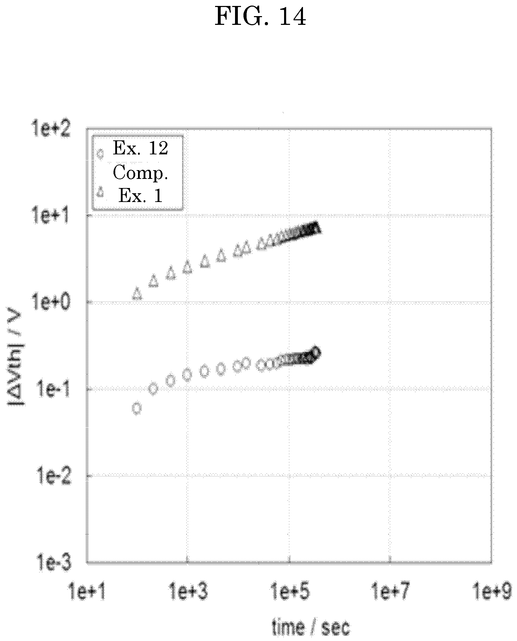

Here, "e" in the vertical axis in the graphs of FIGs. 11, 12, 13, and 14 and in the horizontal axis in the graph of FIG. 14 denotes "the exponent of 10." For example, "le-3" denotes "1.0×10⁻³" and "0.001" and "1e+05" denotes "1.0×10⁺⁵" and "100,000."

It is found from FIG. 11 and Table 3 that the field-effect transistor produced in Example 12 had excellent transistor characteristics before the formation of the passivation layer, and the excellent transistor characteristics were maintained even after the formation of the passivation layer. Similarly, it is found from Table 3 that all of the field-effect transistors produced in Examples 1 to 15 had excellent transistor characteristics before the formation of the passivation layer, and the excellent transistor characteristics were maintained even after the formation of the passivation layer.

On the other hand, it is found from FIG. 12 and Table 3 that the field-effect transistor produced in Comparative Example 1 had poor transistor characteristics before the formation of the passivation layer, as compared with Examples 1 to 15. Moreover, it is found that the field-effect transistor produced in Comparative Example 2 had excellent transistor characteristics before the formation of the passivation layer, but the transistor characteristics were deteriorated by the formation of the passivation layer.

**Table 3**

| | Transistor characteristics | | | | Transistor characteristics | | | |
|---|---|---|---|---|---|---|---|---|
| | Before formation of passivation layer | | | | After formation of passivation layer | | | |
| | Mobility | On/off ratio | Subthreshold swing | Vth | Mobility | On/off ratio | Subthreshold swing | Vth |
| | [cm²/Vs] | [×10⁸] | [V/decade] | [V] | [cm²/Vs] | [×10⁸] | [V/decade] | [V] |
| Ex. 1 | 10.0 | 9.1 | 0.27 | 3.0 | 10.0 | 9.0 | 0.26 | 3.1 |
| Ex. 2 | 9.8 | 9.0 | 0.35 | 4.4 | 9.7 | 8.7 | 0.35 | 4.2 |
| Ex. 3 | 8.8 | 8.5 | 0.24 | 3.7 | 8.7 | 8.6 | 0.24 | 3.8 |
| Ex. 4 | 9.3 | 8.8 | 0.28 | 4.9 | 9.3 | 8.6 | 0.28 | 4.8 |
| Ex. 5 | 11.1 | 9.8 | 0.29 | 3.3 | 10.8 | 9.8 | 0.29 | 3.3 |
| Ex. 6 | 10.3 | 9.3 | 0.35 | 3.6 | 10.5 | 9.5 | 0.33 | 3.4 |
| Ex. 7 | 9.9 | 8.2 | 0.33 | 4.4 | 9.8 | 8.3 | 0.33 | 4.2 |
| Ex. 8 | 10.5 | 8.9 | 0.25 | 4.0 | 10.3 | 9.0 | 0.24 | 4.1 |
| Ex. 9 | 12.3 | 9.2 | 0.22 | 4.4 | 12.5 | 9.3 | 0.25 | 4.4 |
| Ex. 10 | 11.5 | 9.9 | 0.21 | 3.9 | 11.1 | 9.8 | 0.20 | 3.8 |
| Ex. 11 | 11.1 | 9.7 | 0.30 | 4.8 | 10.9 | 9.5 | 0.30 | 5.0 |
| Ex. 12 | 12.0 | 10.5 | 0.23 | 3.6 | 12.2 | 11.1 | 0.16 | 4.3 |
| Ex. 13 | 11.1 | 9.9 | 0.22 | 3.9 | 11.0 | 9.8 | 0.20 | 4.2 |
| Ex. 14 | 10.7 | 9.8 | 0.30 | 3.8 | 11.0 | 9.8 | 0.18 | 3.9 |
| Ex. 15 | 11.3 | 10.0 | 0.25 | 3.2 | 11.5 | 10.5 | 0.15 | 3.3 |
| Comp. Ex. 1 | 3.5 | 0.5 | 0.51 | 2.5 | 3.0 | 0.4 | 0.56 | 3.0 |
| Comp. Ex. 2 | 8.1 | 8.2 | 0.33 | 4.2 | 6.6 | 6.9 | 0.42 | 5.3 |

### <Reliability evaluation of field-effect transistor>

A bias temperature stress (BTS) test was performed on each of the field-effect transistors produced in Examples 1 to 15 and Comparative Examples 1 and 2 in the atmosphere (temperature: 50°C and relative humidity: 50%) for 100 hours.

The stress conditions were the following four conditions:
(1) Vgs = +10 V and Vds = 0 V;
(2) Vgs = +10 V and Vds = +10 V;
(3) Vgs = -10 V and Vds = 0 V; and
(4) Vgs = -10V and Vds = +10 V.

Every time the BTS test proceeded for a certain period of time, a relationship (Vgs - Ids) between Vgs and Ids when Vds = +10 V was measured.

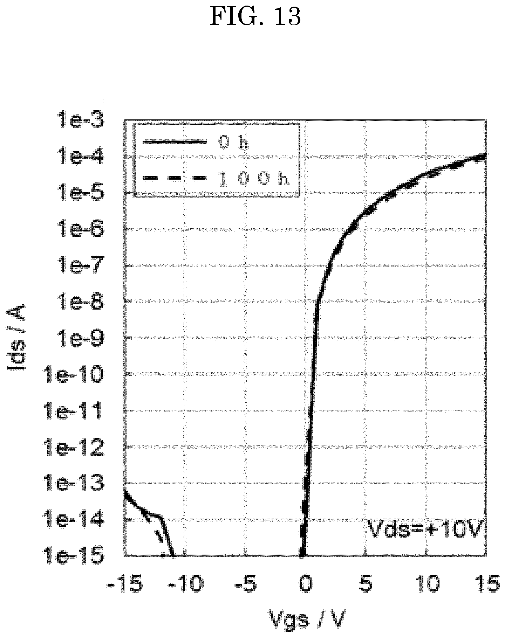

FIG. 13 presents the result of Vgs-Ids in the BTS test performed on the field-effect transistor produced in Example 12, where the stress conditions were Vgs = +10 V and Vds = 0 V. FIG. 14 presents the change of the threshold voltage (ΔVth) with respect to the stress time in each of the field-effect transistors produced in Example 12 and Comparative Example 1 under the stress conditions of Vgs = +10 V and Vds = 0 V. Table 4 presents the values of ΔVth with respect to the stress time of 100 hours in the BTS test performed on each of the field-effect transistors of Examples 1 to 15 and Comparative Examples 1 and 2. Here, "ΔVth" denotes a change of Vth from 0 hours of the stress time through a certain stress time.

It could be confirmed from FIGs. 13 and 14 and Table 4 that the field-effect transistor produced in Example 12 had a small shift in ΔVth and exhibited excellent reliability in the BTS test. Similarly, it could be confirmed from Table 4 that each of the field-effect transistors produced in Examples 1 to 15 had a small shift in ΔVth and exhibited excellent reliability in the BTS test.

On the other hand, as presented in FIG. 14 and Table 4, the field-effect transistor produced in Comparative Example 1 had a large shift in ΔVth and exhibited insufficient reliability in the BTS test. Similarly, as presented in Table 4, the field-effect transistor produced in Comparative Example 2 had a large shift in ΔVth and exhibited insufficient reliability in the BTS test.

**Table 4**

| | After application of stress for 100 hours | | | |
|---|---|---|---|---|
| | Stress conditions | Stress conditions | Stress conditions | Stress conditions |
| | Vgs = +10 V | Vgs = +10 V | Vgs = -10 V | Vgs = -10 V |
| | Vds = 0 V | Vds = +10 V | Vds = 0 V | Vds = +10 V |
| | ΔVth | ΔVth | ΔVth | ΔVth |
| | [V] | [V] | [V] | [V] |
| Ex. 1 | 0.42 | 0.38 | 0.21 | 0.28 |
| Ex. 2 | 0.36 | 0.41 | 0.29 | 0.23 |
| Ex. 3 | 0.46 | 0.33 | 0.28 | 0.26 |
| Ex. 4 | 0.33 | 0.38 | 0.24 | 0.27 |
| Ex. 5 | 0.42 | 0.34 | 0.28 | 0.22 |
| Ex. 6 | 0.36 | 0.37 | 0.19 | 0.21 |
| Ex. 7 | 0.39 | 0.29 | 0.15 | 0.18 |
| Ex. 8 | 0.30 | 0.35 | 0.24 | 0.22 |
| Ex. 9 | 0.28 | 0.24 | 0.21 | 0.29 |
| Ex. 10 | 0.39 | 0.38 | 0.21 | 0.24 |
| Ex. 11 | 0.36 | 0.39 | 0.28 | 0.21 |
| Ex. 12 | 0.26 | 0.22 | 0.15 | 0.13 |
| Ex. 13 | 0.30 | 0.24 | 0.18 | 0.14 |
| Ex. 14 | 0.35 | 0.27 | 0.18 | 0.19 |
| Ex. 15 | 0.22 | 0.37 | 0.17 | 0.13 |
| Comp. Ex. 1 | 7.4 | 6.3 | -8.0 | -8.2 |
| Comp. Ex. 2 | 4.5 | 4.2 | -5.5 | -5.4 |

## Claims

1. A field-effect transistor comprising:
a substrate (21);
a passivation layer (27);
a gate insulating layer (23) formed between the substrate and the passivation layer;
a source electrode (24) and a drain electrode (25);
a semiconductor layer (26), which is formed at least between the source electrode and the drain electrode and is in contact with the gate insulating layer, the source electrode, and the drain electrode; and
a gate electrode (22), which is in contact with the gate insulating layer and faces the semiconductor layer via the gate insulating layer,
wherein the passivation layer comprises a first complex oxide comprising an alkaline earth metal and a rare-earth element, and
wherein the gate insulating layer comprises a second complex oxide comprising an alkaline earth metal and a rare-earth element,
wherein the first complex oxide comprises at least one of Zr and Hf,
wherein the second complex oxide comprises at least one of Zr and Hf.

2. The field-effect transistor according to any one of claim 1,
wherein the semiconductor layer comprises an oxide semiconductor.

3. A display element comprising:
a light control element configured to control light output according to a driving signal; and
a driving circuit comprising the field-effect transistor according to any one of claims 1 to 2 and configured to drive the light control element.

4. The display element according to claim 3,
wherein the light control element comprises an electroluminescent element, an electrochromic element, a liquid crystal element, an electrophoretic element, or an electrowetting element.

5. An image display device configured to display an image corresponding to image data, the image display device comprising:
a plurality of display elements arranged in a matrix, each of the plurality of display elements being the display element according to claim 3 or 4;
a plurality of wires configured to individually apply gate voltage to the field-effect transistors in the plurality of display elements; and
a display control device configured to individually control the gate voltage of the field-effect transistors via the plurality of wires correspondingly to the image data.

6. A system comprising:
the image display device according to claim 5; and
an image-data-generating device configured to generate image data based on image information to be displayed and to output the image data to the image display device.

## Patentansprüche

1. Feldeffekttransistor, umfassend:
ein Substrat (21);
eine Passivierungsschicht (27);
eine Gateisolationsschicht (23), die zwischen dem Substrat und der Passivierungsschicht gebildet ist;
eine Sourceelektrode (24) und eine Drainelektrode (25);
eine Halbleiterschicht (26),
die mindestens zwischen der Sourceelektrode und der Drainelektrode gebildet ist und mit der Gateisolationsschicht, der Sourceelektrode und der Drainelektrode in Kontakt steht; und
eine Gateelektrode (22),
die in Kontakt mit der Gateisolationsschicht ist und der Halbleiterschicht über die Gateisolationsschicht zugewandt ist,
wobei die Passivierungsschicht ein erstes Komplexoxid umfasst, das ein Erdalkalimetall und ein Seltenerdelement umfasst und
wobei die Gateisolationsschicht ein zweites Komplexoxid umfasst, das ein Erdalkalimetall und ein Seltenerdelement umfasst,
wobei das erste Komplexoxid mindestens eines aus Zr und Hf umfasst,
wobei das zweite Komplexoxid mindestens eines aus Zr und Hf umfasst.

2. Feldeffekttransistor nach einem aus Anspruch 1,
wobei die Halbleiterschicht einen Oxidhalbleiter umfasst.

3. Anzeigeelement, umfassend:
ein Lichtsteuerelement, das konfiguriert ist, um eine Lichtausgabe gemäß einem Ansteuersignal zu steuern; und
eine Ansteuerschaltung, die den Feldeffekttransistor nach einem der Ansprüche 1 bis 2 umfasst und konfiguriert ist, um das Lichtsteuerelement anzusteuern.

4. Anzeigeelement nach Anspruch 3,
wobei das Lichtsteuerelement ein Elektrolumineszenzelement, ein elektrochromes Element, ein Flüssigkristallelement, ein elektrophoretisches Element oder ein Elektrobenetzungselement umfasst.

5. Bildanzeigevorrichtung, die konfiguriert ist, um ein Bild anzuzeigen, das Bilddaten entspricht, wobei die Bildanzeigevorrichtung Folgendes umfasst:
eine Vielzahl von Anzeigeelementen, die in einer Matrix angeordnet sind, wobei jedes der Vielzahl von Anzeigeelementen das Anzeigeelement nach Anspruch 3 oder 4 ist;
eine Vielzahl von Leitungen, die konfiguriert sind, um Gatespannung an die Feldeffekttransistoren in der Vielzahl von Anzeigeelement individuell anzulegen; und
eine Anzeigesteuervorrichtung, die konfiguriert ist, um die Gatespannung der Feldeffekttransistoren durch die Vielzahl von Leitungen entsprechend den Bilddaten individuell zu steuern.

6. System, das Folgendes umfasst:
die Bildanzeigevorrichtung nach Anspruch 5; und
eine Bilddatenerzeugungsvorrichtung, die konfiguriert ist, um Bilddaten basierend auf anzuzeigenden Bildinformationen zu erzeugen und die Bilddaten an die Bildanzeigevorrichtung auszugeben.

## Revendications

1. Transistor à effet de champ comprenant :
un substrat (21) ;
une couche de passivation (27) ;
une couche isolante de grille (23) formée entre le substrat et la couche de passivation ;
une électrode source (24) et une électrode de drain (25) ;
une couche semi-conductrice (26),
qui est formé au moins entre l'électrode de source et l'électrode de drain et est en contact avec la couche isolante de grille, l'électrode de source et l'électrode de drain; et
une électrode de grille (22),
qui est en contact avec la couche isolante de grille et fait face à la couche semi-conductrice via la couche isolante de grille,
dans lequel la couche de passivation comprend un premier oxyde complexe comprenant un métal alcalino-terreux et un élément de terre rare, et
dans lequel la couche isolante de grille comprend un deuxième oxyde complexe comprenant un métal alcalino-terreux et un élément de terre rare,
dans lequel le premier oxyde complexe comprend au moins l'un de Zr et Hf,
dans lequel le deuxième oxyde complexe comprend au moins l'un de Zr et Hf.

2. Transistor à effet de champ selon la revendication 1,
dans lequel la couche semi-conductrice comprend un semi-conducteur à base d'oxyde.

3. Elément d'affichage comprenant :
un élément de commande de lumière configuré pour contrôler la sortie de lumière en fonction d'un signal d'attaque ; et
un circuit d'attaque comprenant le transistor à effet de champ selon l'une quelconque des revendications 1 à 2 et configuré pour attaquer l'élément de commande de lumière.

4. Elément d'affichage selon la revendication 3,
dans lequel l'élément de commande de lumière comprend un élément électroluminescent, un élément électrochromique, un élément à cristaux liquides, un élément électrophorétique ou un élément d'électromouillage.

5. Dispositif d'affichage d'image configuré pour afficher une image correspondant à des données d'image, le dispositif d'affichage d'image comprenant :
une pluralité d'éléments d'affichage disposés dans une matrice, chacun de la pluralité d'éléments d'affichage étant l'élément d'affichage selon la revendication 3 ou 4 ;
une pluralité de fils configurés pour appliquer individuellement une tension de grille aux transistors à effet de champ dans la pluralité d'éléments d'affichage ; et
un dispositif de commande d'affichage configuré pour contrôler individuellement la tension de grille des transistors à effet de champ via la pluralité de fils de manière correspondante aux données d'image.

6. Système comprenant :
le dispositif d'affichage d'image selon la revendication 5 ; et
un dispositif générateur de données d'image configuré pour générer des données d'image sur la base d'informations d'image à afficher et pour émettre les données d'image sur le dispositif d'affichage d'image.
